# EUROPÄISCHE PATENTSCHRIFT

(11) **EP 1 859 196 B1**
(45) Veröffentlichungstag und Bekanntmachung des Hinweises auf die Patenterteilung: **03.04.2013**
(21) Anmeldenummer: 06706019.4
(22) Anmeldetag: 28.02.2006
(51) Int. Cl.: F21K 99/00, G02B 17/00

(54) **LICHT EMITTIERENDES MODUL MIT LED UND PASSSTIFTEN FÜR DIE MONTAGE EINES OPTISCHEN ELEMENTS**
LIGHT EMITTING MODULE COMPRISING LEDS AND DOWEL PINS FOR ASSEMBLING AN OPTICAL ELEMENT
MODULE EMETTEUR DE LUMIERE EQUIPE DE DIODES ELECTROLUMINESCENTES ET DE GOUJONS D'ASSEMBLAGE PERMETTANT DE MONTER UN ELEMENT OPTIQUE

(30) Priorität: 16.03.2005 DE 102005012486; 19.07.2005 DE 102005033709
(43) Veröffentlichungstag der Anmeldung: 28.11.2007
(73) Patentinhaber: OSRAM Opto Semiconductors GmbH, 93055 Regensburg (DE)
(72) Erfinder: GRÖTSCH, Stefan, 93077 Lengfeld/Bad Abbach (DE); ENGL, Moritz, 93055 Regensburg (DE); OSWALD, Florin, 60329 Frankfurt am Main (DE); SAILER, Michael, 93098 Wolfskofen (DE); WILM, Alexander, 93059 Regensburg (DE)
(74) Vertreter: Lettenberger, Michael
(86) Internationale Anmeldenummer: PCT/DE2006/000362
(87) Internationale Veröffentlichungsnummer: WO 2006/097067

(56) Entgegenhaltungen:
- EP-A- 1 383 175
- EP-A- 1 519 107
- WO-A-03/048637
- WO-A-2006/021179
- WO-A-2006/045277
- DE-A1-102004 004 778
- GB-A- 2 391 702
- US-A1- 2004 145 821
- US-A1- 2004 183 081

## Beschreibung

Es wird ein Licht emittierendes Modul angegeben.

Eine Aufgabe besteht darin, ein Licht emittierendes Modul anzugeben, das besonders einfach herstellbar ist.

Gemäß zumindest einer Ausführungsform des Licht emittierenden Moduls weist das Licht emittierende Modul eine Lichtquelle auf, die auf einem Träger montiert ist. Bei der Lichtquelle kann es sich z.B. um einen oder mehrere Lumineszenz-Diodenchips handeln.

Der Träger weist beispielsweise Kontaktstellen und Leiterbahnen zur elektrischen Kontaktierung der Lichtquelle auf. Weiter ist der Träger bevorzugt geeignet, beim Betrieb der Lichtquelle entstehende Wärme abzuleiten. Der Träger weist daher bevorzugt eine gute Wärmeleitfähigkeit auf. Beispielsweise handelt es sich bei dem Träger um eine bedruckte Leiterplatte (PCB printed circuit board) oder eine Metallkernplatine.

Gemäß der Ausführungsform des Licht emittierenden Moduls weist das Modul ein optisches Element mit Passstiften auf. D.h., am optischen Element ist zumindest ein Passstift angebracht oder das optische Element ist mit zumindest einem Passstift integral ausgebildet. Erfindungsgemäß greifen die Passstifte des optischen Elements in korrespondierende Ausnehmungen des Trägers. D.h., der Träger weist Ausnehmungen - z.B. Bohrungen - auf, in die die Passstifte des optischen Elements eingreifen können. Bevorzugt ist das optische Element dabei derart auf dem Träger angeordnet, dass zumindest ein Teil der von der Lichtquelle im Betrieb erzeugten elektromagnetischen Strahlung durch das optische Element tritt und von diesem optisch beeinflusst wird.

Gemäß der Ausführungsform des Licht emittierenden Moduls enthält das Licht emittierende Modul eine Lichtquelle, einen Träger für die Lichtquelle und ein optisches Element, wobei das optische Element Passstifte aufweist, die in die korrespondierenden Ausnehmungen des Trägers eingreifen.

Gemäß der Ausführungsform des Licht emittierenden Moduls sind die Passstifte zur Justage des optischen Elements auf den Träger vorgesehen. D.h., die Passstifte wirken als Justagepins, mit denen das optische Element relativ zur Lichtquelle justiert werden kann. Beispielsweise wird das optische Element relativ zur Lichtquelle zentriert. Bevorzugt sind Form, Größe und Anordnung der Ausnehmungen des Trägers sowie Form, Größe und Anordnung der Passstifte des optischen Elements derart aufeinander abgestimmt, dass durch einfaches Einstecken oder Einpressen der Passstifte in die Ausnehmungen eine genaue Justage des optischen Elements relativ zur Lichtquelle erfolgt.

Diese Ausgestaltung des Licht emittierenden Moduls ermöglicht das Anbringen des optischen Elements auf einem Träger mit geringem technischen Aufwand und hoher Präzession. Eine mechanische Verbindung zwischen optischem Element und Träger kann beispielsweise durch ein Haftmittel wie einen Klebstoff vermittelt sein, der zwischen dem optischen Element und dem Träger angeordnet ist.

Gemäß der Ausführungsform des Licht emittierenden Moduls vermitteln die Passstifte eine mechanische Verbindung zwischen dem optischen Element und dem Träger. Dies kann z.B. durch eine Presspassung der Passstifte des optischen Elements in die Ausnehmungen des Trägers erreicht sein. Die laterale Erstreckung der Ausnehmung - d.h., beispielsweise der Durchmesser der Ausnehmung - ist dabei gerade etwas kleiner als die laterale Erstreckung - beispielsweise der Durchmesser - des Passstifts gewählt. Durch mechanisches Einpressen der Passstifte in die korrespondierenden Ausnehmungen des Trägers entsteht dann eine mechanisch feste Verbindung zwischen optischem Element und Träger. Zusätzlich kann zwischen optischem Element und Träger beispielsweise noch ein Haftmittel vorgesehen sein, das zusätzlich eine mechanische Verbindung zwischen diesen beiden Elementen des Licht emittierenden Moduls vermittelt.

Das Dokument WO 03/048637 offenbart die Merkmale des Oberbegriffs des Anspruchs 1. Erfindungsgemäß sind die Passstifte des optischen Elements zur Justage des Licht emittierenden Moduls vorgesehen. Dazu sind die Passstifte bevorzugt so lang ausgestaltet, dass sie durch die Ausnehmung des Trägers auf die dem optischen Element gegenüberliegende Seite des Trägers durchragen. Auf diese Weise können die Passstifte des optischen Elements als Passstifte des gesamten Moduls fungieren. Das Modul kann dann beispielsweise relativ zu einem Modulhalter justiert werden.

Bei dem Modulhalter kann es sich z.B. um einen Kühlkörper handeln, der auch Kühlrippen umfassen kann. Der Modulhalter weist zumindest auf einer seiner zur Montage des Licht emittierenden Moduls vorgesehenen Oberfläche Ausnehmungen auf, in die die Passstifte des optischen Elements eingreifen. Zur mechanischen Befestigung des Licht emittierenden Moduls auf dem Modulhalter kann zwischen Licht emittierenden Modul und Modulhalter ein Haftmittel angeordnet sein. Es ist aber auch möglich, dass das Licht emittierende Modul mittels wenigstens einer Schraube auf dem Modulhalter befestigt ist.

Durch die präzise Justage des Licht emittierenden Moduls relativ zu einem Modulhalter kann gleichzeitig auch eine Justage des Licht emittierenden Moduls relativ zu einem weiteren optischen Element erfolgen, das mit dem Modulhalter verbunden sein kann.

Erfindungsgemäß sind die Passstifte zur mechanischen Befestigung des Moduls vorgesehen. D.h., die Passstifte ragen durch die Ausnehmungen des Trägers auf die dem optischen Element gegenüberliegende Seite der Trägers durch. Das Licht emittierende Modul wird dann auf einen Modulhalter aufgebracht der zu den Passstiften korrespondierende Ausnehmungen aufweist, in die die Passstifte eingreifen. Die laterale Erstreckung von Ausnehmung und Passstift sind dabei derart an einander angepasst, dass durch ein Anpressen des Licht emittierenden Moduls an den Modulhalter eine mechanisch feste Verbindung zwischen Modulhalter und Licht emittierenden Modul entsteht. D.h., das Licht emittierende Modul kann mittels der Passstifte durch eine Presspassung mit dem Modulhalter verbunden sein. Darüber hinaus ist es möglich, dass das Licht emittierende Modul zusätzlich mittels eines Haftvermittlers wie beispielsweise eines Klebstoffs oder mit wenigstens einer Schraube auf dem Modulhalter befestigt ist.

Gemäß zumindest einer Ausführungsform des Licht emittierenden Moduls sind die Passstifte des optischen Elements ferner zur Justage eines weiten optischen Elements geeignet, das dem Modul nachgeordnet ist. Bei dem weiteren optischen Element kann es sich um eine Sekundäroptik, wie beispielsweise eine Projektionslinse handeln. Zumindest ein Teil der Strahlung, die durch das optischen Element des Licht emittierenden Moduls tritt, tritt dann nachfolgend durch die Sekundäroptik und wird von dieser optisch beeinflusst.

Das optische Element des Licht emittierenden Moduls weist in dieser Ausführungsform bevorzugt zumindest einen Passstift auf, der sich in Richtung der Sekundäroptik - d.h. also, beispielsweise vom Träger weg - erstreckt. Die Sekundäroptik weist dann eine korrespondierende Ausnehmung auf, in die der Passstift eingreifen kann. Der Passstift kann sich dabei auch sowohl in Richtung Träger als auch in Richtung Sekundäroptik erstrecken, sodass derselbe Passstift sowohl zur Justage des optischen Elements relativ zum Träger als auch zur Justage der Sekundäroptik relativ zum Licht emittierenden Modul dient. Es ist aber auch möglich, dass das optische Element Passstifte aufweist die zur Justage des optischen Elements geeignet sind, und andere Passstifte, die zur Justage der Sekundäroptik vorgesehen sind.

Gemäß zumindest einer Ausführungsform des Licht emittierenden Moduls sind Passstifte des optischen Elements zur mechanischen Befestigung des weiteren optischen Elements vorgesehen. Dies kann beispielsweise mittels einer Presspassung erfolgen, wie sie weiter oben bereits erläutert ist.

Gemäß zumindest einer Ausführungsform des Licht emittierenden Moduls sind weitere Passstifte zur Montage des Licht emittierenden Moduls auf einem Modulhalter, etwa einem Kühlkörper und/oder Passstifte zur Montage eines Optikkörpers des optischen Elements in einem Halter des optischen Elements vorgesehen. Weitergehend können diese Passstifte gesondert vorgesehen, dem optischen Element, dem Optikkörper bzw. dem Halter angeformt sein, oder auch mit den oben beschriebenen Passstiften des optischen Elements zusammen fallen.

Insgesamt macht sich das beschriebene Licht emittierende Modul u.a. die Idee zu Nutzen, dass mittels Passstiften, die am optischen Element angebracht sind, oder mit diesem integral ausgebildet sind, eine besonders präzise Justage des optischen Elements relativ zu einer Lichtquelle erfolgen kann. Weiter ist es möglich, dass mittels derselben Passstifte oder weiterer Passstifte eine Justage des Licht emittierenden Moduls relativ zu einem Modulhalter und/oder einer Sekundäroptik erfolgen kann. Insgesamt kann so auf besonders einfache Weise eine sehr genau justierte optische Anordnung erzeugt sein, bei der einer Lichtquelle ein erstes optisches Element und gegebenenfalls ein weiteres optisches Element nachgeordnet ist.

Gemäß zumindest einer Ausführungsform des Licht emittierenden Moduls sind die Passstifte des optischen Elements im Querschnitt sternförmig ausgebildet. D.h., zumindest jenes Ende eines Passstifts, das in eine korrespondierende Ausnehmung des Trägers eingreift, weist eine sternförmige Querschnittsfläche auf. Auf diese Weise können Schwankungen in der Maßhaltigkeit, d.h., beispielsweise Schwankungen der lateralen Erstreckung der Ausnehmungen des Trägers oder der lateralen Erstreckung der Passstifte, besonders gut ausgeglichen werden. Dabei liegt u.a. die Erkenntnis zugrunde, dass ein sternförmig ausgebildeter Passstift sich einer Ausnehmung, in die er eingepresst wird, besser anpassen kann, als wenn der Passstift beispielsweise als Vollzylinder mit glatten Mantelflächen ausgebildet ist.

Gemäß zumindest einer Ausführungsform des Licht emittierenden Moduls weist zumindest ein Passstift des optischen Elements entlang des Passstifts einen variierenden Durchmesser auf. Der Durchmesser kann z.B. längs des Passstiftes derart variiert sein, dass er unterschiedlichen Durchmessern der Ausnehmungen des Trägers, des Modulhalters und/oder der Sekundäroptik angepasst ist. Weiter ist es möglich, dass die Passstifte derart ausgebildet sind, dass das optischen Element gleichsam auf Beinen steht, die sich entlang des optischen Elements erstrecken. Das Ende eines solchen Passstifts, das beispielsweise in die Ausnehmung eines Trägers eingreift, kann einen geringeren Durchmesser aufweisen, als der restliche Passstift. Weiter ist es möglich, dass sich der Querschnitt der Passstifte in axialer Richtung kontinuierlich ändert. Der Passstift ist dann als Pyramiden- oder Kegelstumpf ausgeführt.

Gemäß zumindest einer Ausführungsform des Licht emittierenden Moduls ist um zumindest einen der Passstifte ein Reservoir beispielsweise für ein Haftmittel angeordnet. Das Reservoir kann z.B. in Form einer umlaufenden Nut um den Passstift ausgebildet sein. Wird das optische Element mittels eines Haftmittels, wie z.B. eines Klebstoffs, auf dem Träger befestigt ist die Nut geeignet, überschüssiges Haftmittel aufzunehmen.

Gemäß zumindest einer Ausführungsform des Licht emittierenden Moduls umfasst das optische Element einen Halter und einen Optikkörper. Der Halter ist dabei geeignet, den Optikkörper mechanisch zu halten. Bevorzugt sind am Halter die Passstifte des optischen Elements angebracht oder integral mit dem Halter ausgebildet. Der Optikkörper stellt die eigentliche optische Komponente des optischen Elements dar. Der Optikkörper ist beispielsweise zur Strahlformung der durch ihn tretenden Strahlung geeignet. Der Halter ist bevorzugt derart am Optikkörper angebracht oder mit dem Optikkörper verbunden, dass er die optischen Eigenschaften des Optikkörpers möglichst nicht oder nur kaum beeinflusst.

Gemäß zumindest einer Ausführungsform des Licht emittierenden Moduls ist der Optikkörper als optischer Konzentrator ausgebildet, der sich zur Lichtquelle hin verjüngt. Gemäß zumindest einer Ausführungsform des Moduls kann der Optikkörper zumindest stellenweise nach Art wenigstens eines der folgenden optischen Grundelemente gebildet sein: zusammengesetzter parabolischer Konzentrator (CPC - compound parabolic concentrator), zusammengesetzter elliptischer Konzentrator (CEC - compound elliptic concentrator), zusammengesetzter hyperbolischer Konzentrator (CHC - compound hyperbolic concentrator). D.h., die Seitenflächen des optischen Elements sind zumindest stellenweise nach Art eines dieser optischen Grundelemente geformt. Es ist ferner möglich, dass der optische Konzentrator zumindest stellenweise nach Art eines Kegelstumpfes oder eines Pyramidenstumpfes geformt ist, der sich zur Lichtquelle hin verjüngt. Der Optikkörper kann als Vollkörper ausgebildet sein. Es ist aber auch möglich, dass der Optikkörper durch einen Hohlkörper gegeben ist, dessen Innenflächen reflektierend ausgestaltet, beispielsweise reflektierend beschichtet sind.

Gemäß zumindest einer Ausführungsform des Licht emittierenden Moduls umfasst der Optikkörper des optischen Elements eine Strahlungsaustrittsfläche, die auf eine der folgenden Arten gekrümmt sein kann: sphärisch, asphärisch, elliptisch.

Gemäß zumindest einer Ausführungsform des Licht emittierenden Moduls ist der Optikkörper des optischen Elements als Vollkörper ausgebildet. Der Optikkörper enthält dann bevorzugt ein transparentes Material. Reflexionen an den Seitenflächen des Optikkörpers erfolgen dann bevorzugt durch Totalreflexion. Bevorzugt enthält der Optikkörper einen transparenten Kunststoff oder besteht aus einem solchen. Besonders bevorzugt enthält der Optikkörper eines der folgenden Materialien oder besteht aus einem dieser Materialien: PMMA, PMMI, PC, Makrolon, APEC, Glas.

Gemäß zumindest einer Ausführungsform des Licht emittierenden Moduls umfasst der Halter des optischen Elements den Optikkörper seitlich. Der Halter ist dabei z.B. rahmenförmig um die Lichtquelle herum ausgeführt. Der Optikkörper sitzt dann auf dem Halter auf, ist an den Halter angeformt, oder auf sonstige Weise am Halter befestigt. Am Halter können Passstifte ausgebildet sein, die in die korrespondierenden Ausnehmungen des Trägers greifen. Halter und Optikkörper können einstückig ausgebildet sein. D.h., sie sind integral miteinander verbunden. Es ist aber auch möglich, dass das optische Element mehrstückig ausgebildet ist. Der Halter ist dann ein separates Element, in das der Optikkörper eingesteckt, eingelegt, eingeklipst oder eingeklebt sein kann.

Gemäß zumindest einer Ausführungsform des Moduls weist der Halter des optischen Elements stellenweise gekrümmte Seitenflächen auf. Der Halter kann dazu beispielsweise zumindest stellenweise nach Art eines Hohlzylinders ausgebildet sein. Nach Art eines Hohlzylinders heißt dabei, dass die Seitenwände des Halters zumindest stellenweise nach Art eines Zylinders mit kreisförmiger, elliptischer oder ovaler Grundfläche gekrümmt sind. Stellenweise können die Seitenwände des Halters dann aber auch eben, d.h. ohne Krümmung, ausgebildet sein. Solch ebene Bereiche der Seitenwände des Halters können z.B. die Montage und Herstellung des optischen Elements erleichtern.

Der rahmenförmige Halter macht sich u.a. die Erkenntnis zu nutze, dass thermische Verspannungen des optischen Elements von solch einem Halter besonders gut kompensiert werden. Erwärmt sich das optische Element bei Betrieb der Lichtquelle, so dehnt sich der auf dem Träger befestigte Halter vom Träger weg gerichtet aus. Der Optikkörper ist bevorzugt an der dem Träger abgewandten Oberseite des Halters an zumindest zwei Stellen am Halter befestigt. Er dehnt sich daher von der Oberseite des Halters weg in Richtung des Trägers aus. Bevorzugt weisen Halter und Optikkörper einen angepassten Temperaturausdehnungskoeffizienten auf. Dazu können Halter und Optikkörper beispielsweise aus dem gleichen Material bestehen.

Auf diese Weise kompensieren sich die thermische Ausdehnung des Halters vom Träger weg und des Optikkörpers zum Träger hin. Der Abstand einer Lichteintrittsfläche des Optikkörpers von der Lichtquelle bleibt auf diese Weise zumindest annähernd konstant.

Weist der Halter des optischen Elements zusätzlich zumindest stellenweise gekrümmte Seitenflächen auf, so werden auch thermische Verspannungen des optischen Elements in einer zum Träger parellen Ebene besonders effizient kompensiert. Diese Bauform des optischen Elements erlaubt dann eine besonders präzise Positionierung des optischen Elements relativ zu einer Lichtquelle in einer Ebene parallel zum Träger, auch bei Erwärmung des Moduls.

Gemäß zumindest einer Ausführungsform des Licht emittierenden Moduls ist das optische Element boxartig ausgebildet. D.h., z.B. der Halter des optischen Elements ist nach Art einer Box geformt, die auch gekrümmte Seitenflächen aufweisen kann. Der Halter umschließt die Lichtquelle, die auf dem Träger angeordnet ist, bevorzugt von wenigsten vier Seiten. D.h., das optische Element stellt neben seinen optischen Eigenschaften einen Schutz der Lichtquelle vor mechanischer Belastung und Verschmutzung dar.

Gemäß zumindest einer Ausführungsform des Licht emittierenden Moduls ist das optische Element einstückig ausgebildet. D.h., alle Bestandteile des optischen Elements wie Passstifte, Halter und Optikkörper sind integral miteinander verbunden. Alle Teile des optischen Elements bestehen dann bevorzugt aus demselben Material. Das optische Element kann in diesem Fall bevorzugt durch ein Spritzgussverfahren hergestellt sein.

Gemäß zumindest einer Ausführungsform des Licht emittierenden Moduls ist das optische Element mehrstückig ausgebildet. D.h., zumindest ein Teil des optischen Elements wie Passstift, Optikkörper oder Halter ist getrennt von anderen Bestandteilen des optischen Elements gefertigt. Auch in diesem Fall können die einzelnen Bestandteile mittels eines Spritzgussverfahren gefertigt sein. Es ist in diesem Fall jedoch möglich,, unterschiedliche Komponenten aus unterschiedlichen Materialien zu fertigen. Ferner ist es möglich, dass beispielsweise der Halter nicht transparent ausgebildet wird, sondern gefärbt oder geschwärzt ist.

Gemäß zumindest einer Ausführungsform des Licht emittierenden Moduls umfasst die Lichtquelle zumindest einen Leuchtdiodenchip. Besonders bevorzugt umfasst die Lichtquelle eine Mehrzahl von Leuchtdiodenchips in Dünnfilmbauweise.

Ein Dünnfilm-Leuchtdiodenchip kann sich insbesondere durch folgende Merkmale auszeichnen:
- An einer zu einem Trägerelement hingewandten ersten Hauptfläche einer strahlungserzeugenden Epitaxieschichtfolge ist eine reflektierende Schicht aufgebracht oder ausgebildet, die zumindest einen Teil der in der Epitaxieschichtfolge erzeugten elektromagnetischen Strahlung in diese zurück reflektiert. Bei der reflektierenden Schicht handelt es sich beispielsweise um einen Bragg-Spiegel. Besonders bevorzugt handelt es sich um einen Metallspiegel, der beispielsweise durch eine dünne Schicht gebildet ist, die wenigstens ein Material der Gruppe enthält, die Silber, Gold, Gold-Germanium, Aluminium und Platin umfasst.
- Die Epitaxieschichtfolge weist eine Dicke im Bereich von 20 *µ*m oder weniger, insbesondere im Bereich von 10 *µ*m auf. Die Epitaxieschichtfolge enthält zur Erzeugung von elektromagnetischer Strahlung beispielsweise einen pn-Übergang, einen einzelnen Quantentopf oder eine Mehrfachquantentopfstruktur. Die Bezeichnung Quantentopfstruktur umfasst im Rahmen der Anmeldung jegliche Struktur, bei der Ladungsträger durch Einschluss ("confinement") eine Quantisierung ihrer Energiezustände erfahren. Insbesondere beinhaltet die Bezeichnung Quantentopfstruktur keine Angabe über die Dimensionalität der Quantisierung. Sie umfasst somit unter Anderem Quantentröge, Quantendrähte und Quantenpunkte und jede Kombination dieser Strukturen.
- Die Epitaxieschichtfolge enthält mindestens eine Halbleiterschicht mit zumindest einer Fläche, die eine Durchmischungsstruktur aufweist, die im Idealfall zu einer annähernd ergodischen Verteilung des Lichts in der epitaktischen Epitaxieschichtfolge führt, d. h. sie weist ein möglichst ergodisch-stochastisches Streuverhalten auf.

Besonders vorteilhaft ergibt sich, dass das Trägerelement verglichen mit einem Aufwachssubstrat relativ frei gewählt werden kann. So kann der Träger hinsichtlich mancher Eigenschaften, wie etwa elektrischer und/oder thermischer Leitfähigkeit oder Stabilität, für das Bauteil besser geeignet sein als Aufwachssubstrate, die zur Herstellung hochwertiger, epitaktisch gewachsener Schichtfolgen engen Einschränkungen unterliegen. So muss, um hochwertige epitaktische Schichten zu erhalten, das epitaktisch abgeschiedene Material beispielsweise gitterangepasst zum Aufwachssubstrat sein.

Ein Grundprinzip eines Dünnfilm-Leuchtdiodenchips ist beispielsweise in Schnitzer I. et al., "30% external quantum efficiency from surface textured LEDs", Appl. Phys. Lett., Okt 1993, Bd. 63, Seiten 2174 - 2176 beschrieben, deren Offenbarungsgehalt hiermit durch Rückbezug aufgenommen wird.

Gemäß zumindest einer Ausführungsform des Licht emittierenden Moduls sind die Leuchtdiodenchips frei von einer Vergussmasse. Das ist insbesondere dann möglich, wen das optische Element boxartig ausgebildet ist, und die Leuchtdiodenchips von zumindest vier Seiten umschließt. Auf diese Weise sind die Leuchtdiodenchips auch bei Verzicht auf eine Vergussmasse gegen mechanische Belastung und Verschmutzung geschützt.

Gemäß zumindest einer Ausführungsform ist zwischen einem Leuchtdiodenchip der Lichtquelle und einer Lichteintrittsfläche des optischen Elements ein Spalt angeordnet. Der Spalt ist beispielsweise mit einem Gas, bevorzugt mit Luft gefüllt.

Gemäß zumindest einer Ausführungsform des Licht emittierenden Moduls weist das optische Element des Licht emittierenden Moduls mit einem Verguss eines Leuchtdiodenchips der Lichtquelle eine Berührungsfläche auf. Dazu kann eine Lichteintrittsfläche des optischen Elements in einen Verguss des Leuchtdiodenchips gedrückt sein. Der Verguss des Leuchtdiodenchips kann dabei entweder nach dem Aufbringen des optischen Elements ausgehärtet werden, oder es handelt sich um einen weichen, gelartigen Verguss, der nicht ausgehärtet werden muss.

Es ist aber auch möglich, dass der Leuchtdiodenchip zunächst mit einer Vergussmasse vergossen wird, die aushärtet. Anschließend kann der vergossene Leuchtdiodenchip mit einer weiteren Vergussmasse umhüllt werden, die gelartig ist. Bevorzugt härtet diese Vergussmasse nicht vollständig aus. Die Lichteintrittsfläche des optischen Elements wird bei der Montage des optischen Elements auf den Träger dann in diese gelartige Vergussmasse gedrückt. Beispielsweise handelt es sich bei dem gelartigen Verguss um ein Kopplungsgel oder ein Index Matching Gel. Die Vergussmasse ist dabei besonders gut geeignet, eine optische Kopplung zwischen Leuchtdiodenchip und optischem Element herzustellen, sodass nur ein kleiner oder gar kein Brechungsindexsprung beim Eintritt von elektronmagnetischer Strahlung aus der Lichtquelle in das optische Element erfolgt.

Gemäß zumindest einer Ausführungsform beträgt der Abstand zwischen Lichteintrittsfläche des optischen Elements und Lichtaustrittsfläche des Leuchtdiodenchips maximal 250 *µ*m, bevorzugt maximal 200 *µ*m. Ein solch geringer Abstand zwischen optischem Element und Leuchtdiodenchip ermöglicht es, einen möglichst großen Anteil der vom Leuchtdiodenchip emittierten elektronmagnetischen Strahlung in das optische Element einzukoppeln.

Gemäß zumindest einer Ausführungsform ist das Licht emittierende Modul als Lichtquelle in einem optischen Projektionsgerät oder in einem Kfz-Scheinwerfer, beispielsweise einem Frontscheinwerfer, vorgesehen.

Gemäß zumindest einer Ausführungsform weist das optische Element mindestens zwei Passstifte auf, die in korrespondierende Ausnehmungen des Trägers eingreifen. Auf diese Weise kann ein Verdrehen der Optik relativ zur Lichtquelle bei der Montage des optischen Elements besonders effizient unterbunden werden. Bevorzugt weist das optische Element drei oder vier Passstifte auf, die in korrespondierende Ausnehmungen des Trägers eingreifen.

Gemäß zumindest einer Ausführungsform ist das optische Element zur Befestigung des optischen Elements auf den Träger geklebt. Weiter ist es möglich, dass die Passstifte heiß verstempelt werden, und auf diese Weise eine mechanische Befestigung des optischen Elements auf dem Träger erfolgt.

Weitere Vorteile, bevorzugte Ausführungsformen und Weiterbildungen des Licht emittierenden Moduls sowie seiner Bestandteile ergeben sich aus den im Folgenden in Verbindung mit den Figuren erläuterten Ausführungsbeispielen. Es zeigen:
Figur 1 eine schematische perspektivische Darstellung eines Ausführungsbeispiels eines Licht emittierenden Moduls mit einer Lichtquelle, einem Träger für die Lichtquelle und einem optischen Element, wobei das optische Element Passstifte aufweist, die in korrespondierende Ausnehmungen des Trägers eingreifen,
Figur 2 eine schematische perspektivische Darstellung eines Ausführungsbeispiels eines vorzugsweise einstückig ausgebildeten optischen Elements für das Licht emittierende Modul,
Figur 3 eine schematische perspektivische Darstellung eines Ausführungsbeispiels eines vorzugsweise einstückig ausgebildeten, rahmenartigen optischen Elements für das Licht emittierende Modul,
Figur 4 eine schematische perspektivische Darstellung eines Ausführungsbeispiels eines vorzugsweise einstückig ausgebildeten optischen Elements für das Licht emittierende Modul mit sternförmigen Passstiften,
Figur 5, 6, 7 und 8 schematische perspektivische Darstellungen von vier Varianten eines Ausführungsbeispiels eines vorzugsweise einstückig ausgebildeten optischen Elements nach Art eines optischen Konzentrators, teilweise in boxartiger Ausführung,
Figur 9a und 9b schematische perspektivische Darstellungen eines Ausführungsbeispiels eines vorzugsweise einstückig ausgebildeten optischen Elements nach Art eines optischen Konzentrators mit Passstiften, die als "Beine" zur Montage auf dem Träger ausgebildet sind, wobei die Passstifte lateral an der Lichtaustrittsfläche des optischen Elements angebracht sind,
Figur 10a und 10b schematische perspektivische Darstellungen eines Ausführungsbeispiels eines mehrstückig ausgebildeten optischen Elements nach Art eines optischen Konzentrators mit einem Optikkörper und einem Halter,
Figur 11 und 12 schematische perspektivische Darstellungen von zwei Varianten eines Ausführungsbeispiels eines vorzugsweise einstückig ausgebildeten optischen Elements nach Art eines optischen Konzentrators, teilweise in boxartiger Ausführung,
Figur 13a, 13b, 13c, 13d, 13e, 13f schematische perspektivische Darstellungen eines Ausführungsbeispiels eines mehrstückig ausgebildeten optischen Elements nach Art eines optischen Konzentrators mit einem Optikkörper und einem Halter bzw. eines entsprechenden Licht emittierenden Moduls,
Figur 14a, 14b und 14c schematische perspektivische Darstellungen eines Ausführungsbeispiels eines Licht emittierenden Moduls mit einem mehrstückig ausgebildeten optischen Element, aufweisend einen Optikkörper und einen Halter,
Figur 15a, 15b, 15c, 15d, 15e, 15f schematische perspektivische Darstellungen eines Ausführungsbeispiels eines Licht emittierenden Moduls gemäß der Erfindung mit einem mehrstückig ausgebildeten optischen Element aufweisend einen Optikkörper und einen Halter, welches auf einem Modulhalter in Form eines Kühlkörpers aufgebracht ist,
Figur 16a, 16b, 16c, 16d und 16e schematische perspektivische Darstellungen eines Ausführungsbeispiels eines Licht emittierenden Moduls mit einem mehrstückig ausgebildeten optischen Element aufweisend einen Optikkörper und einen Halter,
Figur 17a, 17b, 17c, 17d, 17e, 17f schematische perspektivische Darstellungen von zwei Varianten eines Ausführungsbeispiels eines vorzugsweise einstückig ausgebildeten optischen Elements nach Art eines optischen Konzentrators, dem an der Lichtaustrittsseite ein rahmenförmiger, Passstifte aufweisenden Halter angeformt ist,
Figur 18a, 18b, 18c, 18d schematische perspektivische Darstellungen von zwei Varianten eines Ausführungsbeispiels eines vorzugsweise einstückig ausgebildeten optischen Elements nach Art eines optischen Konzentrators, dem an der Lichtaustrittsseite ein rahmenförmiger, Passstifte aufweisenden Halter angeformt ist, und
Figur 19a und 19b schematische Darstellungen eines Licht emittierenden Moduls, umfassend eine Lichtquelle in Form von LED-Chips, die auf einem Träger angeordnet ist.

In den Ausführungsbeispielen und Figuren sind gleiche oder gleichwirkende Bestandteile jeweils mit den gleichen Bezugszeichen versehen. Die dargestellten Elemente der Figuren sind nicht notwendigerweise als maßstabsgerecht anzusehen, vielmehr können einzelne Bestandteile zum besseren Verständnis teilweise übertrieben groß dargestellt sein.

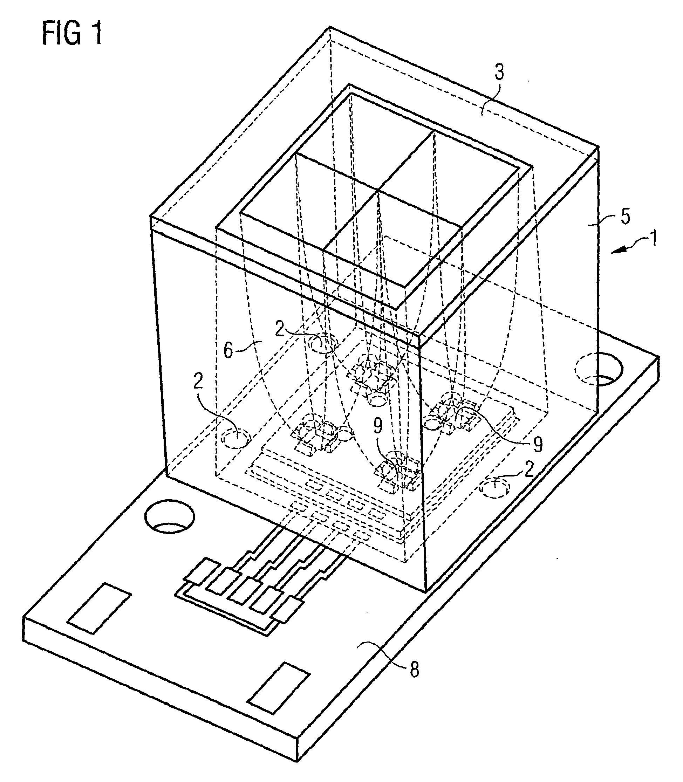

Figur 1 zeigt eine schematische perspektivische Darstellung eines ersten Ausführungsbeispiels des hier beschriebenen Licht emittierenden Moduls. Figur 1 zeigt ein optisches Element 1, das auf einem Träger 8 befestigt ist. Beim Träger 8 handelt es sich z.B. um eine Leiterplatte mit Leiterbahnen, über die die Lichtquellen elektrisch kontaktiert sind. Die Leiterplatte ist beispielsweise durch eine Metallkernplatine gegeben, die ein gut wärmeleitendes Material wie Kupfer oder Aluminium enthalten kann.

Bei den Lichtquellen handelt es sich beispielsweise um Leuchtdiodenchips 9. die Leuchtdiodenchips 9 können auf ein Keramiksubstrat aufgebracht sein. Das Keramiksubstrat weist vorzugsweise Durchkontaktierungen, z.B. Vias, auf, über die die Leuchtdiodenchips 9 elektrisch leitend mit den Leiterbahnen des Trägers verbunden sind. Das Keramiksubstrat enthält dabei bevorzugt zumindest eines der folgenden Materialien: Aluminiumnitrit, Aluminiumoxid, Glaskeramik, Glas, Metall.

Das optische Element weist einen Halter 5 und einen Optikkörper 6 auf. Halter 5 und Optikkörper 6 sind im Ausführungsbeispiel der Figur 1 einstückig ausgebildet. Beispielsweise ist das optische Element 1 dazu mittels eines Spritzguss- oder Spritzpressverfahrens hergestellt. Die Optikkörper 6 des optischen Elements 1 sind beispielsweise durch optische Konzentratoren gegeben, die sich zu den Leuchtdiodenchips 9 hin jeweils verjüngen. D.h., in Richtung der Leuchtdiodenchips 9 nimmt die Querschnittsfläche eines jeden Konzentrators ab.

Wie weiter oben beschrieben, können die Seitenflächen der Optikkörper 6 dabei zumindest stellenweise nach Art wenigstens eines der folgenden optischen Elemente ausgebildet sein: CPC, CHC, CEC, Pyramidenstumpf-Optik, Kegelstumpf-Optik. Der Optikkörper 6 kann als Hohlkörper ausgebildet sein, dessen Innenflächen mit einem reflektierenden Material beschichtet sind, das geeignet ist, zumindest einen Großteil der von den Leuchtdiodenchips 9 im Betrieb erzeugten elektronmagnetischen Strahlung zu reflektieren. Bevorzugt sind die Innenflächen des Optikkörpers 6 dann mit einem Metall beschichtet.

Die Optikkörper 6 können zur Verringerung der Divergenz, zur Strahlformung, und/oder zur Durchmischung der durch sie tretenden Strahlung dienen.

Den Optikkörpern 6 ist eine Lichtaustrittsfläche 3 des optischen Elements 1 in Strahlrichtung nachgeordnet. Die Lichtaustrittsfläche ist beispielsweise durch eine transparente Platte gegeben, die bevorzugt aus einem Material gefertigt ist, das den gleichen thermischen Ausdehnungskoeffizienten wie der Halter 5 und die Optikkörper 6 aufweist. Bevorzugt ist die Platte aus demselben Material wie die restlichen Bestandteile des optischen Elements gefertigt. Dazu kann die Lichtaustrittsfläche 3 beispielsweise mit den restlichen Elementen des optischen Elements 1 einstückig ausgebildet sein.

Das optische Element 1 weist Passstifte 2 aus. Die Passstifte 2 sind bevorzugt integral mit dem Halter 5 ausgebildet. Bevorzugt sind sie zusammen mit dem Halter 5 und den Optikkörpern 6 in einem Spritzgussprozess hergestellt.

Im Ausführungsbeispiel der Figur 1 weist das optische Element 1 drei Passstifte auf. Bei den Passstiften handelt es sich um Justagepins, die in korrespondierende Ausnehmungen des Trägers 8 greifen. Das optische Element 1 kann zur mechanischen Befestigung am Träger 8 an der Grenzfläche zwischen Halter 5 und Träger 8 mit einem Haftmittel auf den Träger 8 geklebt sein. Alternativ oder zusätzlich ist es möglich, dass das optische Element 1 mittels der Passstifte 2 durch eine Presspassung mit dem Träger 8 mechanisch verbunden ist. D.h., die Ausnehmungen des Trägers 8 weisen einen etwas geringeren Durchmesser als die Passstifte 2 auf. Beim mechanischen Einpressen der Passstifte 2 in die Ausnehmungen des Trägers erfolgt dann gleichzeitig zur Justage eine mechanische Befestigung des optischen Elements am Träger.

Im Ausführungsbeispiel der Figur 1 ist das optische Element 1 boxartig ausgebildet. D.h., die Seitenflächen des Halters 5 umschließen die Leuchtdiodenchips 9 vollständig nach Art einer Box oder Schachtel. Ein Vergießen der Leuchtdiodenchips 9 kann in diesem Fall entfallen. Die boxartige Ausführung des optischen Elements 1 stellt einen Schutz der Leuchtdiodenchips 9 gegen mechanische Belastung und gegen Verschmutzung dar.

Vorteilhaft können die Optikkörper 6 in diesem Fall besonders gut an die Leuchtdiodenchips angepasst sein. Die Optikkörper 6 können beispielsweise besonders nahe an die Leuchtdiodenchips 9 geführt werden, wodurch die Höhe der Optik geringer gewählt werden kann. Der Abstand zwischen einer Lichteintrittsfläche 4 des Optikkörpers 6 und der Strahlungsaustrittsfläche eines Leuchtdiodenchips 9 beträgt bevorzugt zwischen 100 und 300 *µ*m, besonders bevorzugt zwischen 150 und 250 *µ*m. Eine Einschränkung hinsichtlich des Abstands zwischen Eintrittsfläche 4 des optischen Elements und Strahlungsaustrittsfläche der Leuchtdiodenchips 9 ist in diesem Ausführungsbeispiel lediglich durch eventuell vorhandene Bonddrähte gegeben, über die die Leuchtdiodenchips 9 beispielsweise n-seitig kontaktiert sind. Zwischen Strahlungsaustrittsfläche der Leuchtdiodenchips 9 und Lichteintrittsfläche 4 des optischen Elements 1 befindet sich in diesem Ausführungsbeispiel bevorzugt ein Spalt der mit einem Gas, z.B. Luft gefüllt ist.

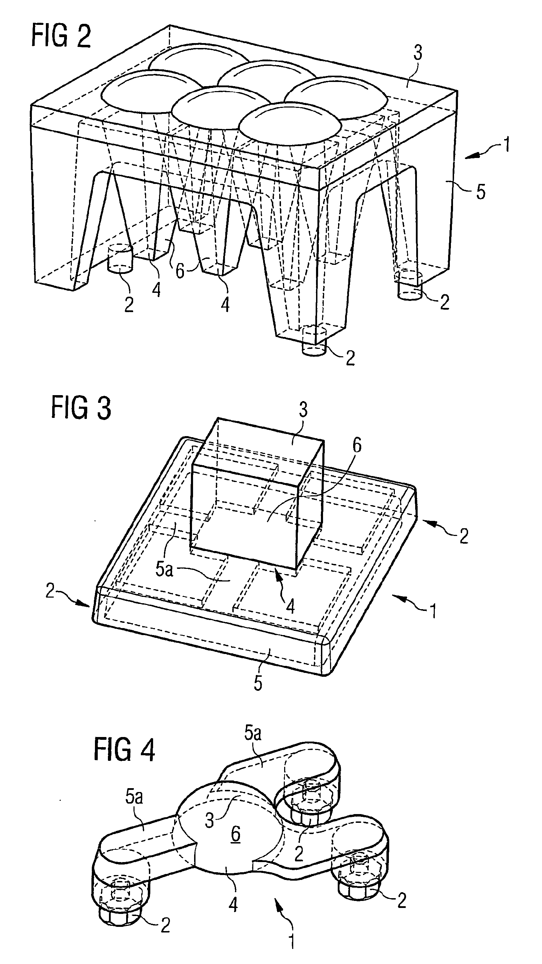

Figur 2 zeigt eine schematische perspektivische Darstellung eines zweiten Ausführungsbeispiels eines vorzugsweise einstückig ausgebildeten optischen Elements 1. Wie schon im Ausführungsbeispiel der Figur 1 weist das optische Element einen Halter 5 und einen Optikkörper 6 auf. Im Gegensatz zum Ausführungsbeispiel der Figur 1 ist das optische Element 1 im Ausführungsbeispiel der Figur 2 nicht boxartig ausgeführt. Die Optikkörper 6 sind vorzugsweise als Vollkörper ausgebildet. Beispielsweise ist das optische Element 1 aus einem transparenten Material wie z.B. einem transparenten Kunststoff gebildet. Das optische Element 1 enthält oder besteht vorzugsweise aus wenigstens einem der folgenden Materialien: COC, PMMA, PMMI, PC, Makrolon, APEC.

Im Ausführungsbeispiel der Figur 2 sind die Optikkörper 6 jeweils nach Art eines Pyramidenstumpfes ausgebildet, der sich zur Lichteintrittsöffnung 4 jedes Optikkörpers 6 hin verjüngt. Die Lichtaustrittsöffnung 3 des optischen Elements 1 ist über jedem Optikkörper 6 linsenartig gewölbt. Dies kann zum einen zur Strahlformung dienen, zum anderen erhöht diese Formgebung der Lichtaustrittsfläche 3 die Auskoppelwahrscheinlichkeit der durch die Optikkörper 6 tretenden elektronmagnetischen Strahlung.

Die linsenartig geformte Lichtaustrittsfläche 3 ist dabei vorzugsweise einstückig mit Halter 5 und Optikkörper 6 ausgebildet. Bevorzugt ist das gesamte optische Element 1 einstückig in einem Spritzguss- oder Spritzpressverfahren hergestellt.

Das optische Element 1 weist ferner Passstifte 2 zur Justage und/oder Befestigung des optischen Elements 1 auf einem Träger 8 auf, die ebenfalls einteilig mit dem optischen Element 1 gebildet sind.

Der Halter 5 umschließt die Optikkörper 6 an ihrer Oberseite, d.h., in Nähe der Lichtaustrittsöffnung 3 des optischen Elements 1. Auf diese Weise ist sicher gestellt, dass die optischen Eigenschaften der Optikkörper 6 möglichst wenig vom Halter 5 beeinflusst werden. So kann beispielsweise Strahlung an der Lichteintrittsöffnung 4 der Optikkörper 6 ohne störende Reflexionen an einen Halter des Optikkörpers 6 in die Optikkörper 6 eingekoppelt werden.

Das optische Element 1 ist beispielsweise auf einem Träger 8 befestigt, wie er im Ausführungsbeispiel der Figur 1 gezeigt ist. Vorzugsweise ist jeder Optikkörper 6 genau einem Leuchtdiodenchip 9 nachgeordnet. Zwischen Optikkörper 6 und Leuchtdiodenchip 9 ist bevorzugt ein Verguss des Leuchtdiodenchips oder ein Index Matching Gel angeordnet. Dadurch ist eine verbesserte optische Ankopplung des Leuchtdiodenchips an dem zugehörigen Optikkörper 6 erreicht. D.h., die Wahrscheinlichkeit von Reflexionen an der Lichteintrittsöffnung 4 ist vermindert. Der Abstand zwischen Strahlungsaustrittsflächen der Leuchtdiodenchips 9 und Lichteintrittsöffnung 4 des Optikkörpers 6 beträgt bevorzugt jeweils ca. 200 *µ*m. Bevorzugt weist der Verguss eines jeden Leuchtdiodenchips 9 und die Lichteintrittsöffnung 4 eines zugehörigen Optikkörpers 6 eine Berührungsfläche auf.

Dazu kann eine Lichteintrittsfläche 4 des optischen Elements 1 in den Verguss des Leuchtdiodenchips 9 gedrückt sein. Der Verguss des Leuchtdiodenchips 9 kann dabei entweder nach dem Aufbringen des optischen Elements 1 ausgehärtet werden, oder es handelt sich um einen weichen, gelartigen Verguss, der nicht ausgehärtet werden muss.

Es ist aber auch möglich, dass der Leuchtdiodenchip 9 zunächst mit einer Vergussmasse vergossen wird, die aushärtet. Anschließend kann der vergossene Leuchtdiodenchip 9 mit einer weiteren Vergussmasse umhüllt werden, die gelartig ist. Bevorzugt härtet diese Vergussmasse nicht komplett aus. Die Lichteintrittsfläche 4 des optischen Elements 1 wird bei der Montage des optischen Elements 1 auf den Träger 8 dann in diese gelartige Vergussmasse gedrückt. Beispielsweise handelt es sich bei dem gelartigen Verguss um ein Kopplungsgel oder ein Index Matching Gel. Die Vergussmasse ist dabei besonders gut geeignet, eine optische Kopplung zwischen Leuchtdiodenchip 9 und optischem Element 1 herzustellen, sodass nur ein kleiner oder gar kein Brechungsindexsprung beim Eintritt von elektronmagnetischer Strahlung aus der Lichtquelle 9 in das optische Element 1 erfolgt.

Figur 3 zeigt ein weiteres Ausführungsbeispiel eines optischen Elements 1. der Optikkörper 6 ist in diesem Ausführungsbeispiel in Form eines Quaders gegeben, der beispielsweise einer Vielzahl von Leuchtdiodenchips 9 nachgeordnet sein kann. Der Quader kann als verspiegelter Hohlkörper oder bevorzugt als Vollkörper ausgebildet sein. In diesem Fall ist der Optikkörper 6 beispielsweise aus einem der o.g. transparenten Kunststoffe gebildet. Der Optikkörper 6 dient als Lichtmischer. Er kann z.B. Leuchtdiodenchips 9 nachgeordnet sein, die geeignet sind, Licht unterschiedlicher Farben abzustrahlen. Der Optikkörper 6 mischt diese Farben dann zu Licht einer einheitlichen Farbe, beispielsweise zu weißem Licht. Der Optikkörper 6 ist vorzugsweise mit einem Halter 5 einstückig ausgebildet. Der Halter 5 weist an wenigstens zwei diagonal gegenüberliegenden Seiten Passstifte 2 zur Justage und/oder Montage des optischen Elements 1 auf einem Träger 8 auf. Vorzugsweise ist das optische Element 1 in einem Spritzguss- oder Spritzpressverfahren hergestellt. Im Ausführungsbeispiel der Figur 3 ist der Optikkörper 6 an der Lichteintrittsöffnung 4 an Stegen 5a des Halters 5 befestigt.

Figur 4 zeigt eine schematische perspektivische Darstellung eines weiteren optischen Elements 1. der Optikkörper 6 ist in diesem Ausführungsbeispiel linsenartig ausgebildet. Insbesondere kann die Lichtaustrittsöffnung 3 des Optikkörpers 6 nach Art einer Sammellinse konvex nach außen gekrümmt sein. Die Lichtaustrittsöffnung 3 weist dabei stellenweise zumindest eine der folgenden Krümmungen auf: sphärisch, asphärisch, elliptisch. Durch die Krümmung der Lichtaustrittsöffnung verringert sich vorteilhaft die Wahrscheinlichkeit für Totalreflexion bei Lichtaustritt aus dem Optikkörper 6. der Optikkörper 6 ist vorzugsweise einer Mehrzahl von Leuchtdiodenchips 9 nachgeordnet. Es ist aber auch möglich, dass das optische Element 1 gemäß dem Ausführungsbeispiel der Figur 4 genau einem Leuchtdiodenchip 9 nachgeordnet ist. Der Optikkörper 6 wird von drei Stegen 5a gehalten, an deren Enden sich vorzugsweise Passstifte 2 zur Justage und/oder Befestigung des optischen Element 1 auf einem Träger 8 befinden. Im gezeigten Ausführungsbeispiel sind Passstifte sternförmig ausgebildet. Dadurch lassen sich Schwankungen bei der Maßhaltigkeit besonders gut ausgleichen. Vorzugsweise ist das optische Element der Figur 4 einstückig ausgebildet und mittels eines Spritzguss- oder eines Spritzpressverfahrens hergestellt.

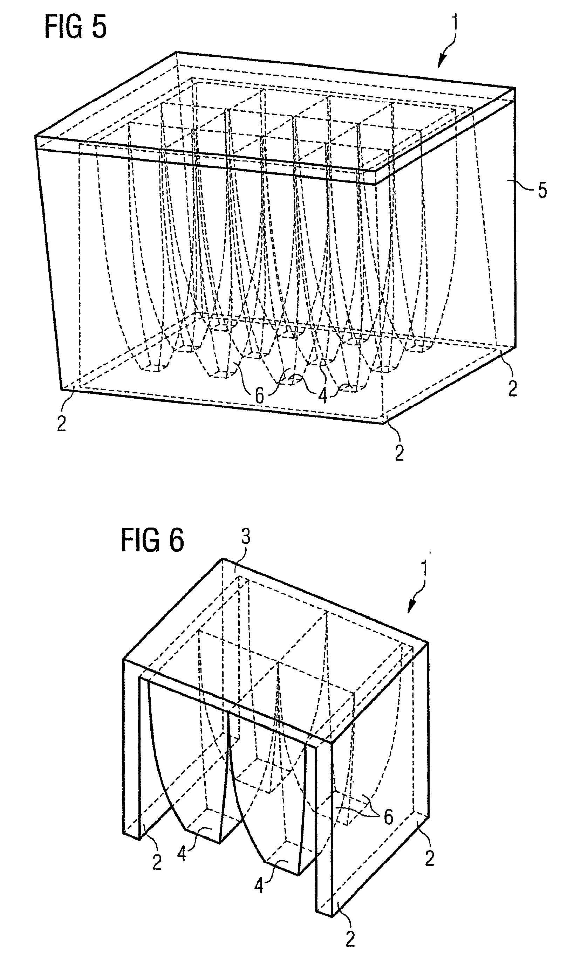

Figur 5 zeigt eine schematische perspektivische Darstellung eines Ausführungsbeispiels eines optischen Elements 1 ähnlich dem in Figur 1 beschriebenen. Das optische Element weist dabei neun Optikkörper 6 auf, die jeweils vorzugsweise einem einzelnen Leuchtdiodenchip 9 nachgeordnet sind. Das optische Element 1 der Figur 5 ist boxartig ausgeführt, sodass bei Bedarf ein Verguss der Leuchtdiodenchips 9 entfallen kann.

Figur 6 zeigt eine schematische perspektivische Darstellung eines weiteren Ausführungsbeispiels eines optischen Elements 1. Im Gegensatz zum Ausführungsbeispiel der Figuren 1 und 5 ist das optische Element 1 nicht boxartig ausgebildet.

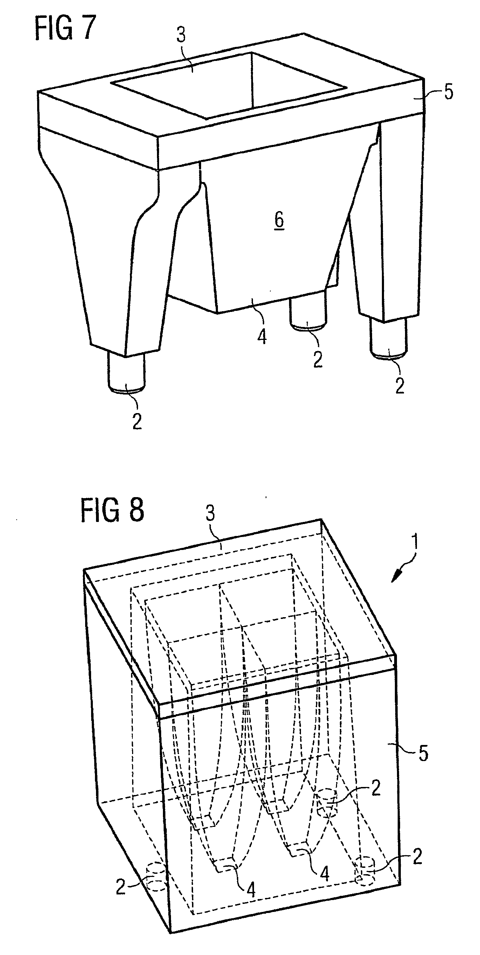

Figur 7 zeigt eine schematische perspektivische Darstellung eines anderen Ausführungsbeispiels des optischen Elements 1. Im Gegensatz zu den Ausführungsbeispielen der Figuren 1, 2, 5 und 6 weist das optische Element 1 einen einzelnen optischen Konzentrator als Optikkörper 6 auf. Der Optikkörper 6 ist z.B. als Hohlkörper ausgebildet, dessen Innenwände reflektierend beschichtet sind. Vorzugsweise ist das optische Element 1, wie es in Figur 7 dargestellt ist, einer Mehrzahl von Leuchtdiodenchips 9 nachgeordnet.

Figur 8 zeigt eine schematische perspektivische Darstellung eines weiteren Ausführungsbeispiels des optischen Elements 1, ähnlich dem in Verbindung mit Figur 1 beschriebenen Ausführungsbeispiels des optischen Elements 1.

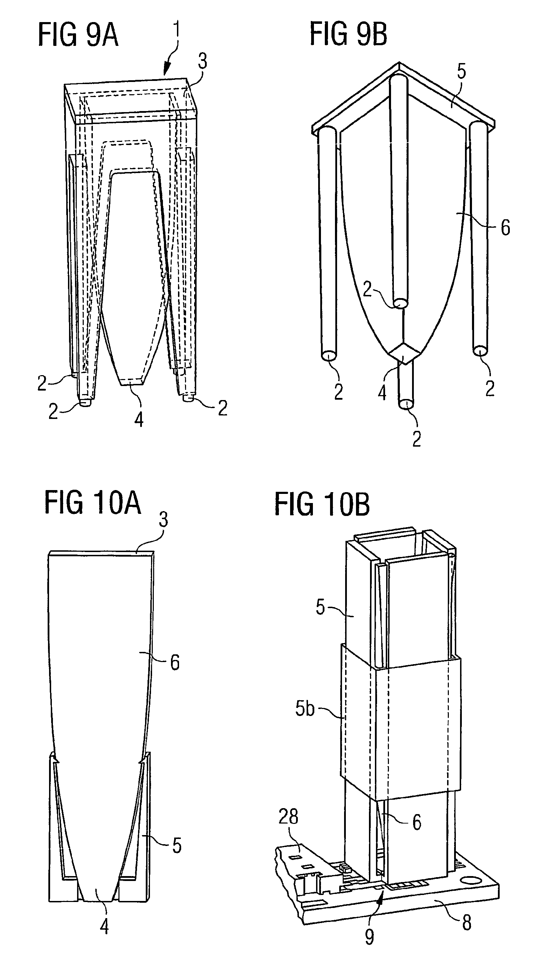

Die Figuren 9a und 9b zeigen schematische perspektivische Darstellungen eines Ausführungsbeispiels eines weiteren optischen Elements. Bei dem Ausführungsbeispielen der Figuren 9a und 9b ist der Optikkörper 6 mit einem Halter 5 einstückig ausgebildet. Der Halter 5 ist dabei teilweise durch die Lichtaustrittsfläche 3 des optischen Elements 1 gebildet. Beine sind lateral an der Lichtaustrittsfläche 3 angebracht und erstrecken sich längs des Optikkörpers 6. Im Ausführungsbeispiel der Figur 9a sind an den der Lichtaustrittsfläche 3 gegenüberliegenden Endseite der Beine Passstifte 2 zur Justage und/oder Befestigung des optischen Elements 1 auf einen Träger 8 angebracht. Beim Ausführungsbeispiel der Figur 9b bilden die Beine selbst Passstifte 2. Vorzugsweise sind die in den Figuren 9a und 9b gezeigten optischen Elemente 1 jeweils einstückig ausgebildet.

Die Figuren 10a und 10b zeigen schematisch perspektivische Darstellungen zweier Ausführungsbeispiele eines mehrstückig ausgebildeten optischen Elements. Im Ausführungsbeispiel der Figur 10a greift der Halter 5 den Optikkörper 6, der vorzugsweise als Vollkörper ausgebildet ist, lediglich an zwei Positionen an. Auf diese Weise werden die optischen Eigenschaften des Optikkörpers 6 nur geringfügig durch den Halter 5 beeinflusst.

Figur 10b zeigt ein optisches Element 1, das vorzugsweise einer Vielzahl von Leuchtdiodenchips 9 nachgeordnet ist. Als Optikkörper 6 ist ein optischer Konzentrator in Seitenwände des Halters 5 eingeklipst. Die Seitenwände des Halters 5 werden durch eine Manschette 5b zusammengehalten, die beispielsweise über die Seitenwände geschoben ist und die Seitenwände stellenweise umfasst. Bei dem eingeklipsten Optikkörper 6 kann es sich sowohl um einen Hohlkörper, dessen Innenflächen reflektierend beschichtet sind, oder um einen Vollkörper handeln.

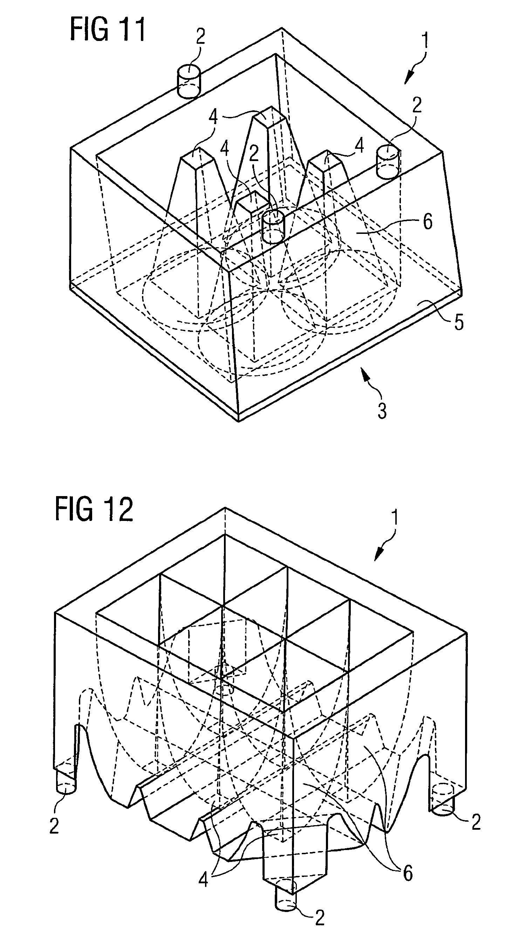

Figur 11 zeigt eine schematische perspektivische Darstellung eines weiteren Ausführungsbeispiels eines optischen Elements 1. Figur 11 zeigt dabei ein optisches Element 1 ähnlich dem des Ausführungsbeispiels der Figur 2. Das optische Element ist boxartig ausgeführt. Die Optikkörper 6 des optischen Elements 1 sind vorzugsweise Vollkörper, die die Form von Pyramidenstümpfen aufweisen. Es können aber auch andere wie beispielsweise im allgemeinen Teil der Beschreibung beschriebene optische Konzentratoren als Optikkörper 6 zum Einsatz kommen.

Figur 12 zeigt eine schematische perspektivische Darstellung eines weiteren Ausführungsbeispiels eines optischen Elements 1 ähnlich dem Ausführungsbeispiel der Figur 1. das optische Element ist dabei jedoch nicht boxartig ausgebildet sondern der Halter 5 ist an vier Seiten zumindest teilweise offen. An vier Ecken des rechteckig geformten optischen Elements 1 befinden sich Passstifte 2 zur Justage und/oder Montage des optischen Elements 1.

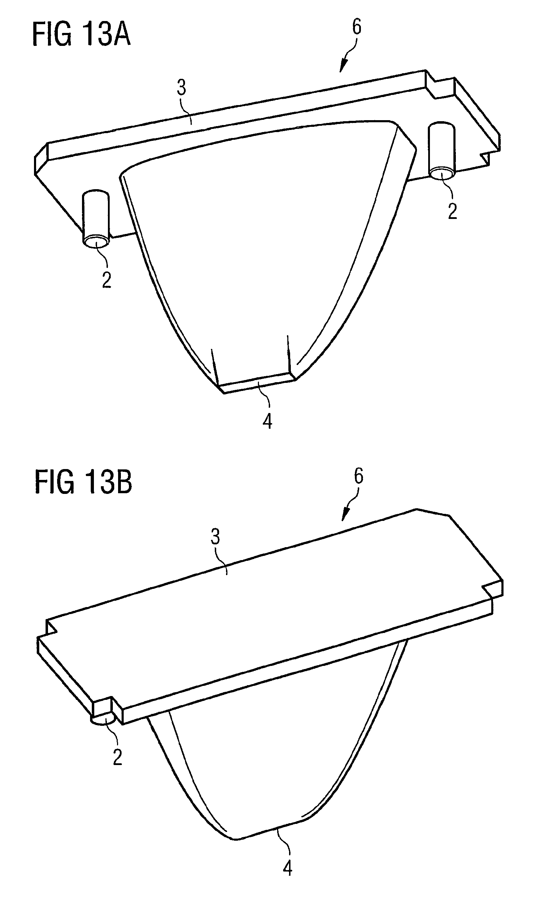

Die Figuren 13a bis 13f zeigen schematisch perspektivische Darstellungen eines weiteren Ausführungsbeispiels des optischen Elements 1. In diesem Ausführungsbeispiel ist das optische Element 1 mehrstückig ausgebildet. Das optische Element 1 weist einen in den Figuren 13a und 13b gezeigten Optikkörper 6 auf. Der Optikkörper 6 besteht aus einem optischen Konzentrator und einer Lichtaustrittsfläche 3. Der optische Konzentrator ist vorzugsweise als Vollkörper ausgebildet, der beispielsweise aus einem der o.g. transparenten Kunststoffe bestehen kann. Der Optikkörper 6 ist im Ausführungsbeispiel der Figuren 13a bis 13f einstückig mit der Lichtaustrittsfläche 3 ausgebildet. Die Lichtaustrittsfläche 3 steht an den seitlichen Rändern über den optischen Konzentrator über, sodass Passstifte 2 zur Justage und/oder mechanischen Befestigung des Optikkörpers 6 in einem Halter 5 frei zugänglich sind.

An der Lichteintrittsfläche 4 des Optikkörpers 6 können beispielsweise eine Mehrzahl von Leuchtdiodenchips 9 angeordnet sein. Beispielsweise sind fünf Leuchtdiodenchips 9 in gerader Linie an der Lichteintrittsfläche 4 angeordnet. Bevorzugt weist der Optikkörper 6 an seiner Lichteintrittsfläche 4 eine Berührungsfläche mit einem Verguss der Leuchtdiodenchips 9 auf. D.h., das optische Element 1 ist mit seiner Lichteintrittsfläche 4 beispielsweise in den Verguss der Leuchtdiodenchips 9 gepresst.

Der in den Figuren 13a und 13b gezeigte Optikkörper 6 ist bevorzugt in einem Spritzgussverfahren oder in einem Spritzpressverfahren gefertigt. Er eignet sich insbesondere für Scheinwerferanwendungen in einem Kraftfahrzeug. Beispielsweise kann durch einen Optikkörper 6, wie er im Zusammenhang mit den Figuren 13a und 13b beschrieben ist, eine relativ breite Lichtverteilung geformt werden, die geeignet ist den Raum vor einem Kraftfahrzeug möglichst gleichmäßig auszuleuchten.

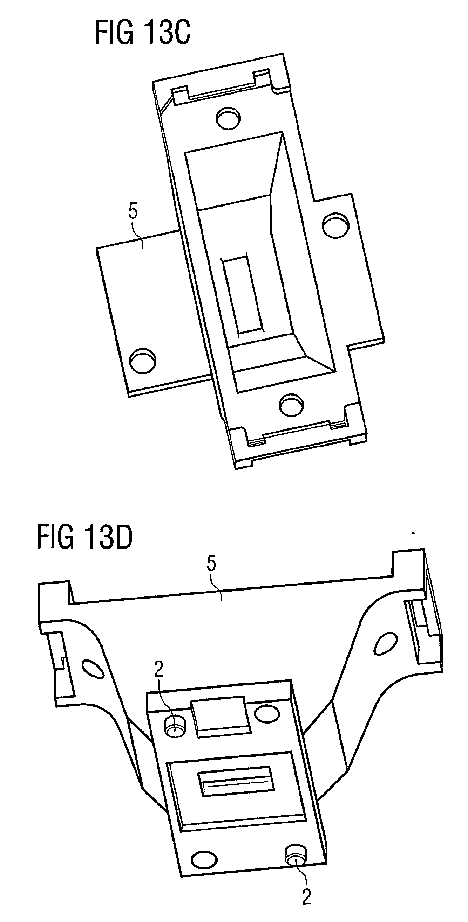

Die Figuren 13c und 13d zeigen einen Halter 5 für den Optikkörper 6 der Figuren 13a und 13b. Der Halter 5 ist derart an den Optikkörper 6 angepasst, dass der Optikkörper 6 in den Halter 5 eingeklipst werden kann und/oder am Rand der Lichtaustrittsfläche 3 mit dem Halter 5 verpresst oder verklebt werden kann. Die Passstifte 2 an der Lichtaustrittsfläche 3 dienen dabei vorzugsweise zur Justage und mechanischen Befestigung des Optikkörpers 6 in den Halter 5. Der Halter 5 weist einen Grundkörper mit einer Öffnung zur Aufnahme des Optikkörpers 6 sowie eine Bodenplatte auf. Die Bodenplatte weist Passstifte 2 zur Justage des Halters 5 auf einen Träger 8 auf. Der Halter 5 ist vorzugsweise einteilig ausgeführt. Der thermische Ausdehnungskoeffizient des Halters 5 ist dem des Optikkörpers 6 angepasst. Der Halter 5 kann beispielsweise aus dem gleichen Material wie der Optikkörper 6 bestehen. Ferner ist es möglich, dass der Halter 5 koloriert oder geschwärzt ist.

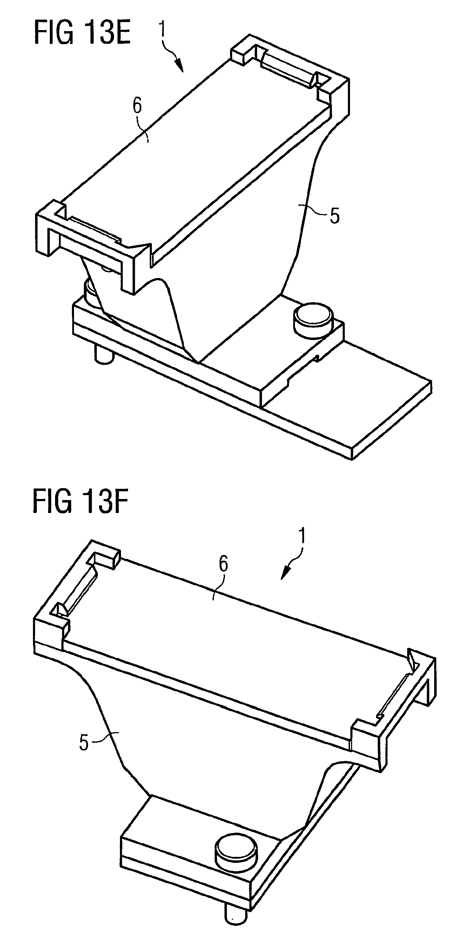

Die Figuren 13f und 13g zeigen das optische Element 1 bestehend aus einem Optikkörper 6 und einem Halter 5 angeordnet auf einem Träger 8, der beispielsweise durch einen wie im Zusammenhang mir der Figur 1 beschriebenen Träger 8 gegeben ist. Der Optikkörper 6 ist dabei in den Halter 5 eingeklipst.

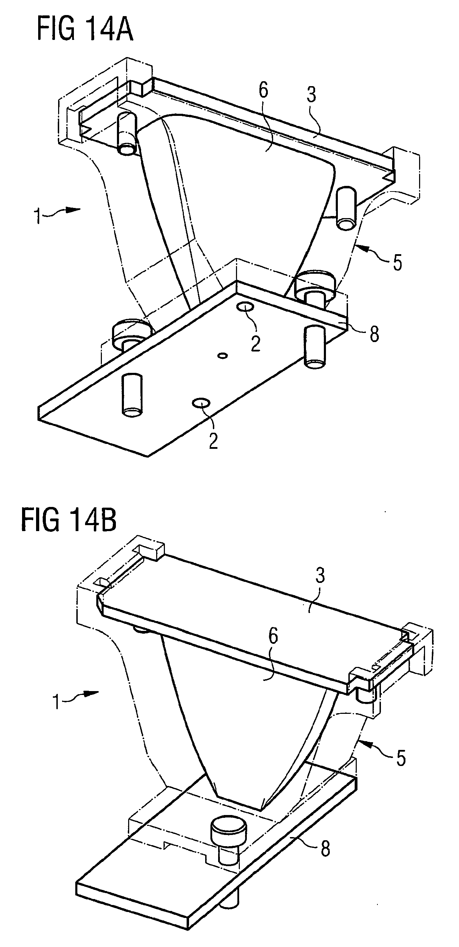

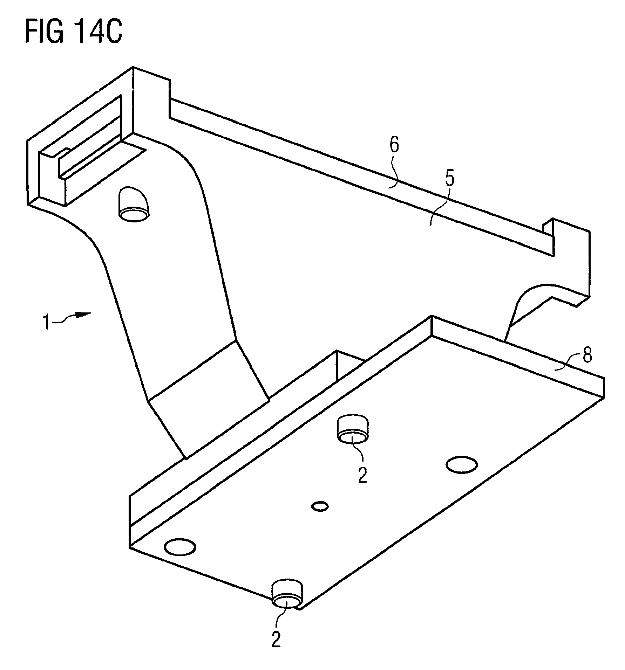

Die Figuren 14a bis 14c zeigen schematisch perspektivische Darstellungen des auf einen Träger 8 montierten optischen Elements 1 der Figuren 13a bis 13f aus unterschiedlichen Perspektiven. In den Figuren 14a und 14c ist zu erkennen, dass Passstifte 2, die auf der Bodenplatte des Halters 5 ausgebildet sind, durch korrespondierende Ausnehmungen des Trägers 8 gesteckt sind und auf der dem optischen Element 1 abgewandten Seite der Trägers 8 hervorstehen. Diese Passstifte 2 können daher für eine Justage und/oder Montage des Moduls bestehend aus optischem Element 1 und Träger 8 auf einem Modulhalter 7 Verwendung finden, wie es im Anspruch 1 vorgesehen ist.

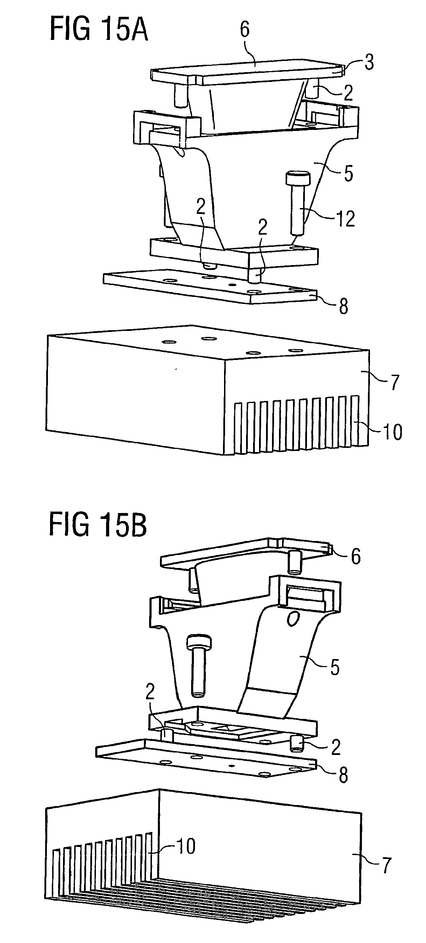

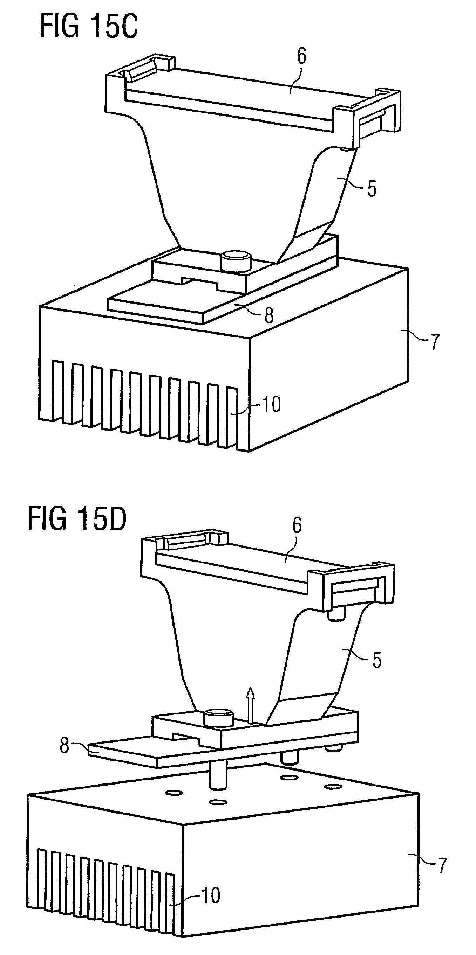

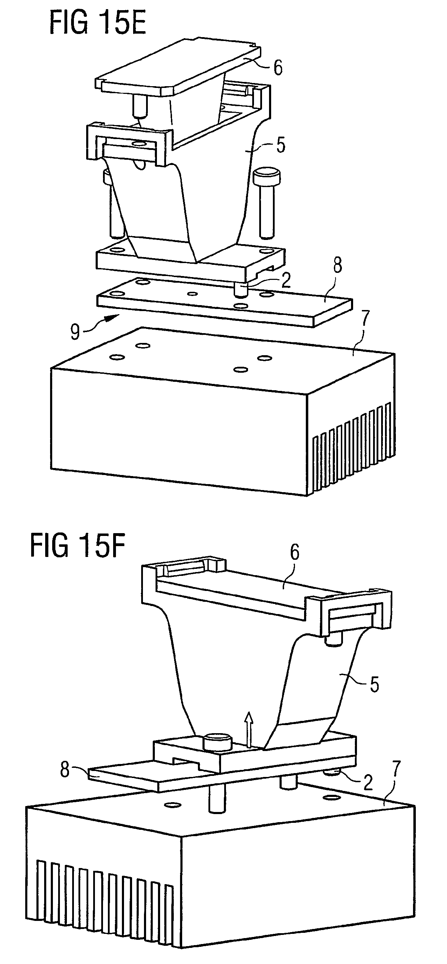

Die Figuren 15a bis 15f zeigen schematische perspektivische Darstellung eines Ausführungsbeispiels eines Licht emittierenden Moduls mit einem optischen Element 1 das auf einem Modulhalter 7 aufgebracht ist.

Bei dem optischen Element 1 handelt es sich beispielsweise um ein mehrstückig ausgebildetes optisches Element, wie es im Zusammenhang mit den Figuren 13 und 14 beschrieben ist. Der Modulhalter 7 ist im Ausführungsbeispiel der Figuren 15a bis 15f als Kühlkörper ausgebildet, der Kühlrippen 10 aufweist. Bevorzugt ist der Montagehalter 7 aus einem gut wärmeleitenden Material wie beispielsweise einem Metall oder einem keramischen Material gebildet. Wie beispielsweise im Zusammenhang mit den Figuren 15a und 15b ersichtlich wird, dienen die Passstifte 2, die auf der Bodenplatte des Halters 5 angeordnet sind, auch zur Justage des Licht emittierenden Moduls auf dem Modulhalter 7. Die Passstifte 2 greifen dazu in korrespondierende Ausnehmungen des Modulhalters 7. Das Modul ist beispielsweise mittels Schrauben 12 auf dem Modulhalter 7 mechanisch befestigt.

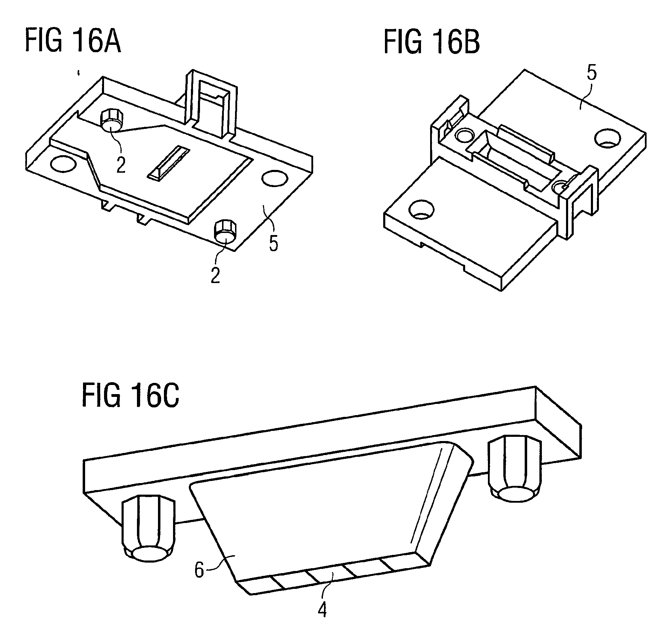

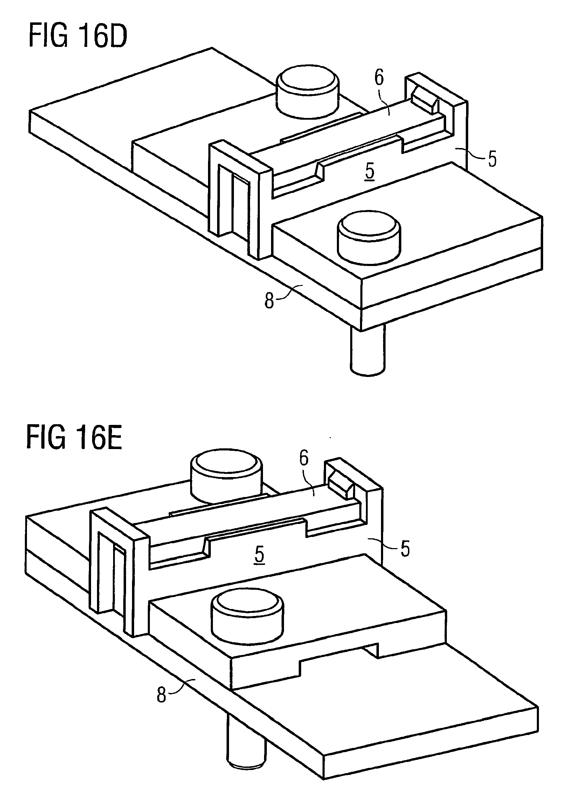

Die Figuren 16a bis 16e zeigen schematische perspektivische Darstellungen eines weiteren Ausführungsbeispiels eines Licht emittierenden Moduls.

Das Modul weist einen Optikkörper 6 ähnlich dem in den Figuren 13a und 13b gezeigten Optikkörper auf. (Siehe dazu auch Figur 16c). Im Unterschied zu den in den Figuren 13a und 13b gezeigten Optikkörper ist der Optikkörper 6 der Figur 16c von geringerer Länge. Er ist z.B. insbesondere zur Erzeugung einer Hotspot Lichtverteilung für das Fernlicht eines Kfz-Scheinwerfers geeignet.

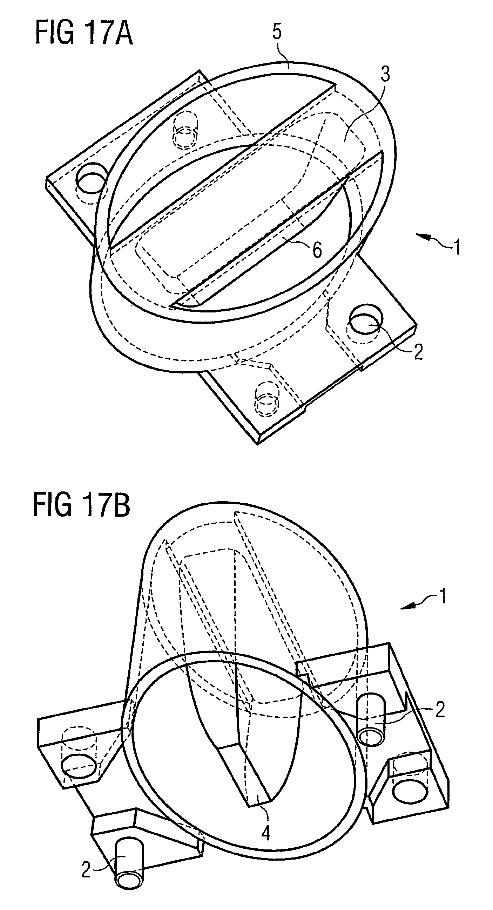

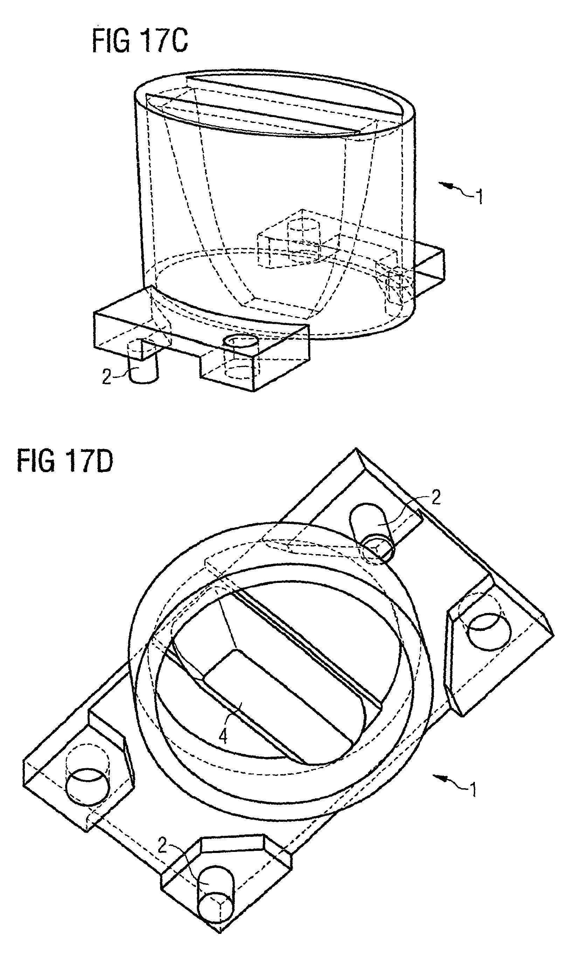

Die Figuren 17a bis 17f zeigen weiter Ausführungsbeispiele eines optischen Elements 1. Das optische Element 1 weist einen Optikkörper 6 auf, der ähnlich dem Optikkörper 6 der Figuren 13 bis 16 ausgebildet ist.

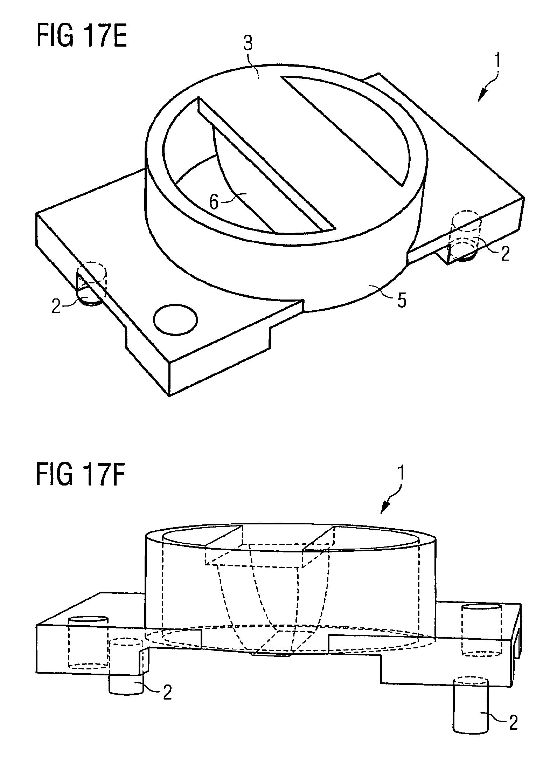

Die Figuren 17a bis 17d zeigen einen Optikkörper 6 für eine breite Lichtverteilung, Figuren 17e und 17f einen Optikkörper 6 für einen Hotspot Verteilung. Im Gegensatz zu den Ausführungsbeispielen der Figuren 13 bis 16 sind die optischen Elemente 1 der Figuren 17a bis 17f einstückig ausgebildet. bevorzugt ist das optische Element 1 dabei durch ein Spritzguss- oder einen Spritzpressverfahren hergestellt.

Das optische Element 1 ist an zwei Stellen mit einem Halter 5 integral verbunden. Bevorzugt ist das optische Element 1 auf der dem Träger 8 abgewandten Seite des Halters 5 mit diesem verbunden. Der Halter 5 ist bevorzugt zumindest stellenweise gekrümmt ausgeführt. D.h. der Halter 5 weist zumindest stellenweise gekrümmte Seitenwände auf. Der Halter 5 der Figuren 17a bis 17f hat die Form eines Hohlzylinders mit ovaler Grundfläche. Das optische Element 1 der Figuren 17a bis 17f macht sich dabei u.a. die Erkenntnis zu Nutze, dass diese Formgebung des Halters 5 thermische Ausdehnungen des optischen Elements besonders gut kompensieren kann. So dehnt sich der Halter 5 bei Erwärmen beispielsweise in Richtung senkrecht zur Bodenplatte des optischen Elements 1, die auf einem Träger 8 befestigt ist, vom Träger 8 weg aus. Der an zwei Stellen mit dem Halter 5 verbundene Optikkörper 6 dehnt sich in Richtung Bodenplatte zum Träger 8 hin aus. Aufgrund der einteiligen Ausführung des optischen Elements 1 weisen Optikkörpers 6 und Halter 5 gleiche thermische Ausdehnungskoeffizienten auf, sodass sich die thermischen Ausdehnung der beiden Elemente gegenseitig kompensieren. Auf diese Weise ist es möglich, dass der Abstand zwischen Leuchtdiodenchips 9 und Lichteintrittsfläche 4 des Optikkörper 6 auch bei Betrieb der Leuchtdiodenchips 9 im wesentlichen konstant gehalten werden kann.

Weiter bewirkt die gekrümmte Form des Halters 5 eine Kompensation thermischer Verspannungen in der Ebene parell zum Träger 8. Beim Träger 8 handelt es sich beispielsweise um eine Metallkernplatine, die sich bei Erwärmung stärker ausdehnt als das optische Element 1. Der gezeigte, zumindest stellenweise gekrümmte Halter 5 ist geeignet, die Verspannungen in der Ebene parell zum Träger 8 zu kompensieren. Auf diese Weise bleibt die Lichteintrittsfläche 4 des optischen Elements 1 auch bei Betrieb der Leuchtdiodenchips 9 in dieser Ebene besonders genau zu den Leuchtdiodenchips 9 justiert.

Die Wandstärke der Seitenwände des optischen Elements 1 beträgt beispielsweise zwischen 1 und 3 mm, bevorzugt zwischen 1,3 und 1,7 mm. Beispielsweise ist die Lichteintrittsfläche 4 des optischen Elements 1 dabei fünf Leuchtdiodenchips 9 nachgeordnet, die entlang einer geraden Linie angeordnet sind.

Der Optikkörper 6 der Ausführungsbeispiele der Figuren 17a bis 17e weist beispielsweise eine Länge von ca. 20 mm auf. D.h., der Abstand von der Lichteintrittsfläche 4 zur Lichtaustrittsfläche 3 beträgt ca. 20 mm. Der kleinere Durchmesser des Halters 5 beträgt an der Lichtaustrittsfläche 3 ca. 15 mm, der größere Durchmesser beträgt ca. 25 mm. Das optische Element 1 der Figuren 17a bis 17c eignet sich besonders gut zur Formung einer breiten Lichtverteilung, die als Grundlichtverteilung eines Kfz-Scheinwerfers dienen kann.

Der Optikkörper 6 der Ausführungsbeispiele der Figuren 17e und 17f weist beispielsweise einen Abstand von der Lichteintrittsfläche 4 zur Lichtaustrittsfläche 3 von ca. 10 mm auf. Der kleinere Durchmesser des Halters 5 beträgt an der Lichtaustrittsfläche 3 in den gezeigten Ausführungsbeispielen ca. 14 mm, der größere Durchmesser ca. 20 mm das optische Element 1 der Figuren 17e und 17f eignet sich besonders gut zur Formung einer Hotspot Lichtverteilung.

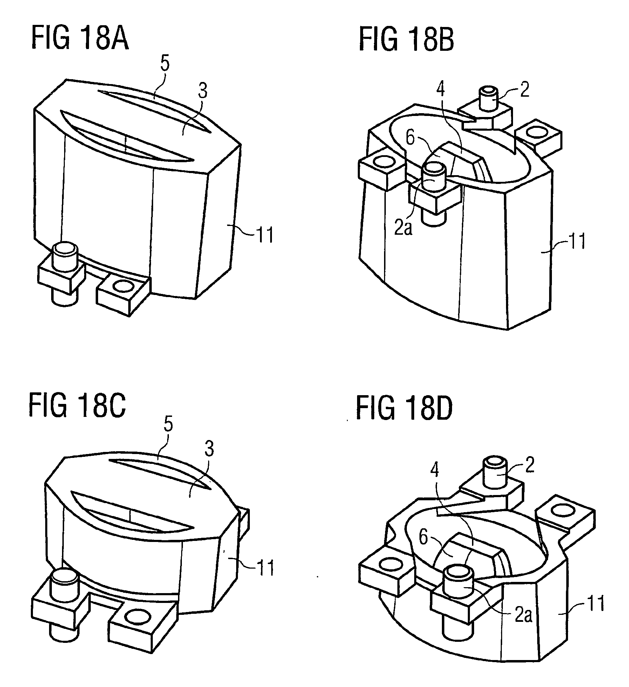

Die Figuren 18a bis 18d zeigen ein weiteres Ausführungsbeispiel eines optischen Elements 1. Im Unterschied zu den optischen Elementen 1 der Figuren 17a bis 17f weist der Halter des optischen Elements 1 der Figuren 18a bis 18d stellenweise ebene Seitenflächen 11 auf, die sich in Richtung der Lichteintrittsöffnung 4 des Optikkörpers 6 leicht verjüngen. Die ebenen Seitenflächen 11 erleichtern eine Herstellung des optischen Elements 1 mittels Spritzguss. Weiter erleichtern die ebenen Seitenflächen 11 die Montage des optischen Elements 1.

Die ebenen Seitenflächen 11 sind durch gekrümmte Seitenflächen des Halters 5 miteinander verbunden, die in der Draufsicht beispielsweise nach Art eines Kreises oder einer Ellipse geformt sind. Wie oben beschrieben, erweist sich der derart stellenweise gekrümmte Halter als besonders vorteilhaft hinsichtlich der Kompensation von thermischen Ausdehnungen in Betrieb der Leuchtdiodenchips 9.

Ebenfalls im Unterschied zum Ausführungsbeispiel der Figuren 17a bis 17f weisen die optischen Elemente der Figuren 18a bis 18d einen Passstift 2a auf, der die Bodenplatte des Halters 5 in zwei Richtungen überragt. Dieser Passstift 2a ermöglicht beispielsweise die Justage einer Sekundäroptik, die dem optischen Element 1 in Hauptabstrahlrichtung der Leuchtdiodenchips 9 nachgeordnet sein kann, relativ zum Licht emittierenden Modul.

Der Optikkörper 6 der Ausführungsbeispiele der Figuren 18a und 18b weist beispielsweise eine Länge von ca. 20 mm auf. D.h., der Abstand von der Lichteintrittsfläche 4 zur Lichtaustrittsfläche 3 beträgt ca. 20 mm. Der kleinere Durchmesser des Halters 5 beträgt an der Lichtaustrittsfläche 3 ca. 15 mm, der größere Durchmesser beträgt ca. 25 mm. Das optische Element 1 der Figuren 18a und 18b eignet sich besonders gut zur Formung einer breiten Lichtverteilung, die als Grundlichtverteilung eines Kfz-Scheinwerfers dienen kann.

Der Optikkörper 6 der Ausführungsbeispiele der Figuren 18c und 18d weist beispielsweise einen Abstand von der Lichteintrittsfläche 4 zur Lichtaustrittsfläche 3 von ca. 10 mm auf. Der kleinere Durchmesser des Halters 5 beträgt an der Lichtaustrittsfläche 3 in den gezeigten Ausführungsbeispielen ca. 14 mm, der größere Durchmesser ca. 20 mm das optische Element 1 der Figuren 18c und 18d eignet sich besonders gut zur Formung einer Hotspot Lichtverteilung.

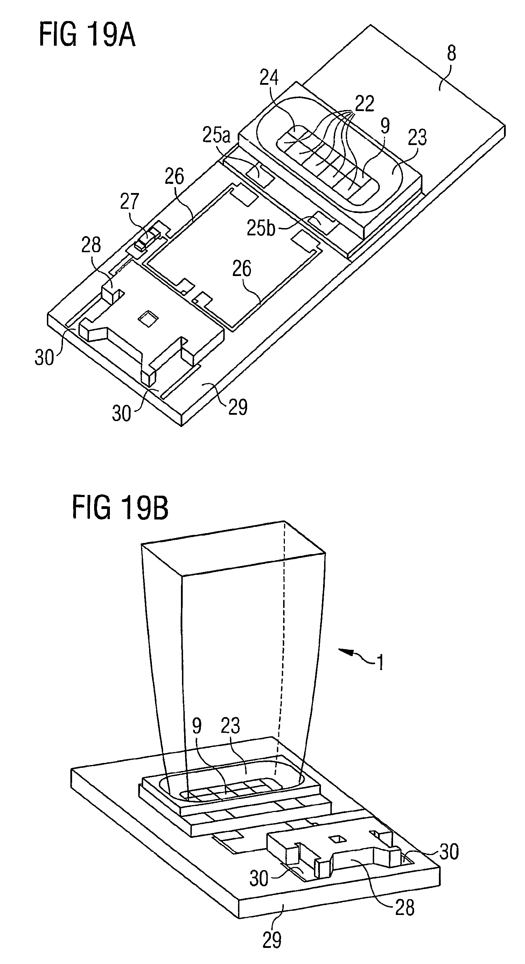

Die in Figur 19a und 19b gezeigte Lichtquelle 9 auf dem Träger 8 umfasst beispielsweise fünf Dünnfilm-LED-Chips 22. Bei den LED-Chips 22 handelt es sich zum Beispiel um Dünnfilm-LED-Chips mit einer Lichtausbeute von jeweils wenigstens 20 Lumen pro Watt. Bevorzugt sind die LED-Chips 22 geeignet Licht im blauen Spektralbereich zu erzeugen. Den LED-Chips 22 ist dann ein Lumineszenzkonversionsmaterial nachgeordnet. Der frequenzkonvertierte Anteil der von den Leuchtdiodechips 22 abgegebenen Strahlung mischt sich mit dem nicht-konvertierten Anteil bevorzugt zu weißem Licht.

Die LED-Chips 22 sind auf einem Träger, zum Beispiel am Boden 24 eines Gehäuses 23 angeordnet. Das Gehäuse 23 kann zum Beispiel aus einem keramischen Material gebildet sein. Bevorzugt weist das Gehäuse 23 Innenwände auf, die zumindest stellenweise reflektierend ausgebildet sind.

Die LED-Chips 22 sind außerhalb des Gehäuses 23 an den Kontaktflächen 25a und 25b kontaktiert. Leiterbahnen 26 verbinden die Kontaktflächen 25a, 25b mit Anschlussstellen 30, über die die Lichtquelle 20 von außen kontaktiert werden kann. Beispielsweise kann der Anschluss der Lichtquelle an das Stromnetz eines Kraftfahrzeuges mittels eines Steckers am Gegenstecker 28 erfolgen. Zumindest ein Varistor 27 fungiert als Überspannungsschutz der Lichtquelle 20. Gegenstecker 28, Varistor 27 sowie Gehäuse 23 sind zum Beispiel auf einer Metallkernplatine 29 angeordnet, die sowohl als Leiterplatte als auch als Wärmeleitelement für die im Betrieb von den LED-Chips 22 erzeugte Wärme fungiert.

Dabei ist es möglich, dass auf der Metallkernplatine 29 oder außerhalb des Licht emittierenden Moduls eine Vorrichtung zum Dimmen der LED-Chips 22 vorgesehen ist. Auf diese Weise kann die Abstrahlcharakteristik des Moduls zusätzlich durch Intensitätsänderung an äußere Bedingungen wie Wetter oder Beleuchtungsverhältnisse angepasst werden. Weiter ist eine Intensitätsänderung des von der Lichtquelle abgestrahlten Lichts auch durch gezieltes Zu- und Abschalten einzelner LED-Chips 22 möglich.

## Patentansprüche

1. Licht emittierendes Modul mit
- einer Lichtquelle (9),
- einem Träger (8) für die Lichtquelle und
- einem optischen Element (1), wobei
- das optische Element (1) Passstifte (2) aufweist, die in korrespondierende Ausnehmungen des Trägers (8) eingreifen,
- die Passstifte (2) das optische Elements (1) auf dem Träger (8) justieren, und wobei
- die Passstifte (2) durch die Ausnehmungen des Trägers auf die dem optischen Element gegenüberliegende Seite des Trägers durchragen und das Modul relativ zu einem Modulhalter (7) justieren, indem sie in korrespondierende Ausnehmungen des Modulhalters (7) eingreifen.

2. Licht emittierendes Modul nach dem vorherigen Anspruch,
bei dem die Passstifte (2) eine mechanische Verbindung zwischen optischem Element (1) und Träger (8) vermitteln.

3. Licht emittierendes Modul nach zumindest einem der vorherigen Ansprüche,
bei dem die Passstifte (2) zur mechanischen Befestigung des Moduls auf dem Modulhalter (7) vorgesehen sind.

4. Licht emittierendes Modul nach zumindest einem der vorherigen Ansprüche,
bei dem die Passstifte (2) zur Justage eines weiteren optischen Elements geeignet sind, das dem Modul nachgeordnet ist.

5. Licht emittierendes Modul nach zumindest einem der vorherigen Ansprüche,
bei dem die Passstifte (2) zur mechanischen Befestigung des weiteren optischen Elements vorgesehen sind.

6. Licht emittierendes Modul nach zumindest einem der vorherigen Ansprüche,
bei dem die Passstifte (2) im Querschnitt sternförmig ausgebildet sind.

7. Licht emittierendes Modul nach zumindest einem der vorherigen Ansprüche,
bei dem der Durchmesser der Passstifte (2) entlang der Passstifte (2) variiert.

8. Licht emittierendes Modul nach zumindest einem der vorherigen Ansprüche,
bei dem um zumindest einen Passstift herum (2) ein Reservoir zur Aufnahme eines Haftmittels angeordnet ist.

9. Licht emittierendes Modul nach zumindest einem der vorherigen Ansprüche,
bei dem das optische Element (1) einen Halter (5) und einen Optikkörper (6) umfasst.

10. Licht emittierendes Modul nach zumindest einem der vorherigen Ansprüche,
bei dem der Optikkörper (6) als ein optischer Konzentrator ausgebildet ist, der sich zur Lichtquelle (9) hin verjüngt.

11. Licht emittierendes Modul nach zumindest einem der vorherigen Ansprüche,
bei dem der Optikkörper (6) als Vollkörper ausgebildet ist.

12. Licht emittierendes Modul nach dem vorherigen Anspruch,
bei dem der Optikkörper (6) eines der folgenden Materialien enthält: PMMA, PMMI, PC, Makrolon, APEC, COC.

13. Licht emittierendes Modul nach zumindest einem der vorherigen Ansprüche,
bei dem der Halter (5) den Optikkörper (5) seitlich umfasst.

14. Licht emittierendes Modul nach zumindest einem der vorherigen Ansprüche,
bei dem der Halter (5) stellenweise gekrümmte Seitenflächen aufweist.

15. Licht emittierendes Modul nach zumindest einem der vorherigen Ansprüche,
bei dem der Halter (5) zumindest stellenweise nach Art eines Hohlzylinders ausgebildet ist, der den Optikkörper (6) seitlich umschließt.

16. Licht emittierendes Modul nach zumindest einem der vorherigen Ansprüche,
bei dem das optische Element (1) boxenartig ausgebildet ist.

17. Licht emittierendes Modul nach zumindest einem der vorherigen Ansprüche,
bei dem das optische Element (1) die Lichtquelle (9) von zumindest vier Seiten umschließt.

18. Licht emittierendes Modul nach zumindest einem der vorherigen Ansprüche,
bei dem das optische Element (1) einstückig ausgebildet ist.

19. Licht emittierendes Modul nach zumindest einem der Ansprüche 1 bis 18,
bei dem das optische Element (1) mehrstückig ausgebildet ist.

20. Licht emittierendes Modul nach zumindest einem der vorherigen Ansprüche,
bei dem die Lichtquelle (9) zumindest einen Leuchtdiodenchip umfasst.

21. Licht emittierendes Modul nach zumindest einem der vorherigen Ansprüche,
bei dem ein Leuchtdiodenchip frei von einer Vergussmasse ist.

22. Licht emittierendes Modul nach zumindest einem der vorherigen Ansprüche,
bei dem zwischen einem Leuchtdiodenchip der Lichtquelle und einer Lichteintrittsfläche (4) des optischen Elements (1) ein Spalt angeordnet ist, der Luft enthält.

23. Licht emittierendes Modul nach zumindest einem der vorherigen Ansprüche,
bei dem das optische Element (1) mit einem Verguss eines Leuchtdiodenchips eine Berührungsfläche aufweist.

24. Licht emittierendes Modul nach zumindest einem der vorherigen Ansprüche,
bei dem der Abstand zwischen Leuchtdiodenchip und Lichteintrittsfläche (4) des optischen Elements (1) höchstens 250 µm beträgt.

25. Licht emittierendes Modul nach zumindest einem der vorherigen Ansprüche,
das als Beleuchtungseinrichtung in einem optischen Projektionsgerät oder einem Kfz-Scheinwerfer vorgesehen ist.

## Claims

1. Light-emitting module comprising
- a light source (9),
- a carrier (8) for the light source and
- an optical element (1),
- the optical element (1) having fitting pins (2) which engage into corresponding cutouts in the carrier (8),
- the fitting pins (2) aligning the optical element (1) on the carrier (8), and
- the fitting pins (2) projecting through the cutouts in the carrier onto the opposite side of the carrier to the optical element and aligning the module relative to a module holder (7) by engaging into corresponding cutouts in the module holder (7).

2. Light-emitting module according to the preceding claim,
in which the fitting pins (2) impart a mechanical connection between optical element (1) and carrier (8).

3. Light-emitting module according to at least one of the preceding claims,
in which the fitting pins (2) are provided for the mechanical fixing of the module on the module holder (7).

4. Light-emitting module according to at least one of the preceding claims,
in which the fitting pins (2) are suitable for the alignment of a further optical element arranged downstream of the module.

5. Light-emitting module according to at least one of the preceding claims,
in which the fitting pins (2) are provided for the mechanical fixing of the further optical element.

6. Light-emitting module according to at least one of the preceding claims,
in which the fitting pins (2) are formed in star-shaped fashion in cross section.

7. Light-emitting module according to at least one of the preceding claims,
in which the diameter of the fitting pins (2) varies along the fitting pins (2).

8. Light-emitting module according to at least one of the preceding claims,
in which a reservoir for receiving an adhesive agent is arranged around at least one fitting pin (2).

9. Light-emitting module according to at least one of the preceding claims,
in which the optical element (1) comprises a holder (5) and an optical body (6).

10. Light-emitting module according to at least one of the preceding claims,
in which the optical body (6) is formed as an optical concentrator that tapers towards the light source (9).

11. Light-emitting module according to at least one of the preceding claims,
in which the optical body (6) is formed as a solid body.

12. Light-emitting module according to the preceding claim,
in which the optical body (6) contains one of the following materials: PMMA, PMMI, PC, Macrolon, APEC, COC.

13. Light-emitting module according to at least one of the preceding claims,
in which the holder (5) laterally encompasses the optical body (6).

14. Light-emitting module according to at least one of the preceding claims,
in which the holder (5) has side areas that are curved in places.

15. Light-emitting module according to at least one of the preceding claims,
in which the holder (5) is formed at least in places in the manner of a hollow cylinder that laterally encloses the optical body (6).

16. Light-emitting module according to at least one of the preceding claims,
in which the optical element (1) is formed like a box.

17. Light-emitting module according to at least one of the preceding claims,
in which the optical element (1) encloses the light source (9) from at least four sides.

18. Light-emitting module according to at least one of the preceding claims,
in which the optical element (1) is formed in one piece.

19. Light-emitting module according to at least one of Claims 1 to 18,
in which the optical element (1) is formed in a plurality of pieces.

20. Light-emitting module according to at least one of the preceding claims,
in which the light source (9) comprises at least one light-emitting diode chip.

21. Light-emitting module according to at least one of the preceding claims,
in which a light-emitting diode chip is free of an encapsulation composition.

22. Light-emitting module according to at least one of the preceding claims,
in which a gap containing air is arranged between a light-emitting diode chip of the light source and a light entrance area (4) of the optical element (1).

23. Light-emitting module according to at least one of the preceding claims,
in which the optical element (1) has an area of contact with an encapsulation of a light-emitting diode chip.

24. Light-emitting module according to at least one of the preceding claims,
in which the distance between light-emitting diode chip and light entrance area (4) of the optical element (1) is at most 250 µm.

25. Light-emitting module according to at least one of the preceding claims,
which is provided as an illumination device in an optical projection apparatus or a motor vehicle headlight.

## Revendications

1. Module émetteur de lumière avec
- une source lumineuse (9),
- un support (8) pour la source lumineuse et
- un élément optique (1),
- l'élément optique (1) comportant des goujons d'assemblage (2) pénétrant dans les cavités correspondantes du support (8),
- les goujons d'assemblage (2) ajustant l'élément optique (1) sur le support (8), et
- les goujons d'assemblage (2) traversant les évidements du support jusqu'à la face du support opposée à l'élément optique et ajustant le module par rapport à un support de module (7) en pénétrant dans les cavités correspondantes du support de module (7).

2. Module émetteur de lumière selon la revendication précédente, dans lequel les goujons d'assemblage (2) assurent une liaison mécanique entre élément optique (1) et support (8).

3. Module émetteur de lumière selon une au moins des revendications précédentes,
dans lequel les goujons d'assemblage (2) sont prévus pour la fixation mécanique du module sur le support de module (7).

4. Module émetteur de lumière selon une au moins des revendications précédentes,
dans lequel les goujons d'assemblage (2) sont aptes à l'ajustage d'un autre élément optique placé en aval du module.

5. Module émetteur de lumière selon une au moins des revendications précédentes,
dans lequel les goujons d'assemblage (2) sont prévus pour la fixation mécanique de l'autre élément optique.

6. Module émetteur de lumière selon une au moins des revendications précédentes,
dans lequel les goujons d'assemblage (2) sont réalisés avec une coupe transversale en forme d'étoile.

7. Module émetteur de lumière selon une au moins des revendications précédentes,
dans lequel le diamètre des goujons d'assemblage (2) varie le long des goujons d'assemblage (2).

8. Module émetteur de lumière selon une au moins des revendications précédentes,
dans lequel un réservoir pour contenir un adhésif est disposé autour d'au moins un goujon d'assemblage (2).

9. Module émetteur de lumière selon une au moins des revendications précédentes,
dans lequel l'élément optique (1) comporte un support de maintien (5) et un corps optique (6).

10. Module émetteur de lumière selon une au moins des revendications précédentes,
dans lequel le corps optique (6) est réalisé en forme de concentrateur optique qui se rétrécit en direction de la source lumineuse (9).

11. Module émetteur de lumière selon une au moins des revendications précédentes,
dans lequel le corps optique (6) est réalisé en forme de corps plein.

12. Module émetteur de lumière selon la revendication précédente,
dans lequel le corps optique (6) contient un des matériaux suivants : PMMA, PMMI, PC, Makrolon, APEC, COC.

13. Module émetteur de lumière selon une au moins des revendications précédentes,
dans lequel le support de maintien (5) englobe latéralement le corps optique (6).

14. Module émetteur de lumière selon une au moins des revendications précédentes,
dans lequel le support de maintien (5) comporte par endroits des faces latérales incurvées.

15. Module émetteur de lumière selon une au moins des revendications précédentes,
dans lequel le support de maintien (5) est réalisé au moins par endroits sous la forme d'un cylindre creux englobant latéralement le corps optique (6).

16. Module émetteur de lumière selon une au moins des revendications précédentes,
dans lequel l'élément optique (1) est réalisé sous la forme d'une boîte.

17. Module émetteur de lumière selon une au moins des revendications précédentes,
dans lequel l'élément optique (1) englobe la source lumineuse (9) sur au moins quatre côtés.

18. Module émetteur de lumière selon une au moins des revendications précédentes,
dans lequel l'élément optique (1) est réalisé sous la forme d'une seule pièce.

19. Module émetteur de lumière selon une au moins des revendications 1 à 18,
dans lequel l'élément optique (1) est réalisé sous la forme de plusieurs pièces.

20. Module émetteur de lumière selon une au moins des revendications précédentes,
dans lequel la source lumineuse (9) comporte au moins une puce de diode électroluminescente.

21. Module émetteur de lumière selon une au moins des revendications précédentes,
dans lequel la puce de diode électroluminescente est dépourvue de produit de moulage.

22. Module émetteur de lumière selon une au moins des revendications précédentes,
dans lequel une fente contenant de l'air est disposée entre une puce de diode électroluminescente de la source lumineuse et une surface d'entrée de la lumière (4) de l'élément optique (1).

23. Module émetteur de lumière selon une au moins des revendications précédentes,
dans lequel l'élément optique (1) comporte une surface de contact avec un produit de moulage d'une puce de diode électroluminescente.

24. Module émetteur de lumière selon une au moins des revendications précédentes,
dans lequel la distance entre puce de diode électroluminescente et surface d'entrée de la lumière (4) de l'élément optique (1) s'élève au maximum à 250 µm.

25. Module émetteur de lumière selon une au moins des revendications précédentes,
prévu comme dispositif d'éclairage dans un appareil optique de projection ou un phare de véhicule automobile.
